(19) Europäisches Patentamt
European Patent Office
Office européen des brevets

(11) EP 1 699 899 B1

(12) # EUROPÄISCHE PATENTSCHRIFT

(45) Veröffentlichungstag und Bekanntmachung des Hinweises auf die Patenterteilung:
**23.08.2017 Patentblatt 2017/34**

(21) Anmeldenummer: **04816265.5**

(22) Anmeldetag: **16.12.2004**

(51) Int Cl.:
***C09K 11/78*** *(2006.01)* ***C09K 11/79*** *(2006.01)*
***C09K 11/80*** *(2006.01)*

(86) Internationale Anmeldenummer:
**PCT/DE2004/002756**

(87) Internationale Veröffentlichungsnummer:
**WO 2005/061659 (07.07.2005 Gazette 2005/27)**

(54) **LEUCHTSTOFF UND LICHTQUELLE MIT DERARTIGEM LEUCHTSTOFF**

LUMINOUS SUBSTANCE AND LIGHT SOURCE COMPRISING SUCH A LUMINOUS SUBSTANCE

SUBSTANCE LUMINESCENTE ET SOURCE LUMINEUSE DOTEE D'UNE TELLE SUBSTANCE

(84) Benannte Vertragsstaaten:
**BE DE FR GB IT NL**

(30) Priorität: **22.12.2003 DE 10360546**

(43) Veröffentlichungstag der Anmeldung:
**13.09.2006 Patentblatt 2006/37**

(73) Patentinhaber: **OSRAM GmbH**
**80807 München (DE)**

(72) Erfinder:
- **FIEDLER, Tim**
**81377 München (DE)**
- **FRIES, Torsten**
**86391 Stadtbergen (DE)**
- **JERMANN, Frank**
**81739 München (DE)**
- **ZACHAU, Martin**
**82269 Geltendorf (DE)**
- **ZWASCHKA, Franz**
**85737 Ismaning (DE)**

(74) Vertreter: **Epping - Hermann - Fischer Patentanwaltsgesellschaft mbH**
**Postfach 20 07 34**
**80007 München (DE)**

(56) Entgegenhaltungen:
**EP-A- 1 121 000** **US-A- 4 314 910**
**US-A- 4 550 256** **US-A1- 2002 195 587**
**US-A1- 2003 001 495**

- **SHMULOVICH J ET AL: "SINGLE-CRYSTAL RARE-EARTH-DOPED YTTRIUM ORTHOSILICATE PHOSPHORS" JOURNAL OF THE ELECTROCHEMICAL SOCIETY, ELECTROCHEMICAL SOCIETY. MANCHESTER, NEW HAMPSHIRE, US, Bd. 135, Nr. 12, 1. Dezember 1988 (1988-12-01), Seiten 3141-3151, XP000134318 ISSN: 0013-4651**

EP 1 699 899 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

### Technisches Gebiet

Die Erfindung geht aus von einem Leuchtstoff und Lichtquelle mit derartigem Leuchtstoff gemäß dem Oberbegriff des Anspruchs 1. Es handelt sich dabei insbesondere um einen Granat-basierten Leuchtstoff, der sich zur Anwendung bei Lichtquellen wie LEDs und Lampen eignet.

### Stand der Technik

Aus der DE-GM 201 08 013 ist bereits ein Leuchtstoff und Lichtquelle mit derartigem Leuchtstoff bekannt, bei dem ein Leuchtstoff ein Granat bestimmter Seltene Erden ist. die Anwendung verschiedener Seltene Erden gibt die Möglichkeit, den Farbort des Leuchtstoffs in gewissen Grenzen einzustellen. Allerdings sind derartige Leuchtstoffe, wenn nicht Y die hauptsächliche Komponente des von Seltene Erdenbesetzten Gitterplatzes darstellt, wenig stabil oder sie besitzen wenig Effizienz oder nur geringe Absorptionsfähigkeit. Zwar kann im Granat Al durch Ga teilweise ersetzt werden. insbesondere bei diesen bekannten Leuchtstoffen mit Farbort im Grünen Spektralbereich ist die Anregbarkeit und damit einhergehend die Effizienz der Konversion nicht zufriedenstellend. Eine weitere Beschränkung des gewünschten Farborts eines bekannten Granat-Leuchtstoffs zur Realisierung einer weißen LED liegt darin, dass des öfteren eine relativ hohe Cer-Konzentration dafür erforderlich ist, die jedoch herstellungstechnisch nur sehr aufwendig zu realisieren ist.
Aus US-A4 550 256 ist ein Leuchtstoff bekannt, der auf YAG basiert und bei dem Paare von Gruppe II und Gruppe IV Elementen, insbesondere Ca einerseits und Si oder Ge andererseits, zugesetzt sein können. Anwendungsgebiet ist hauptsächlich CRT.
Bisher mussten zur Realisierung bestimmter Farborte, die beispielsweise einer neutralweißen oder warmweißen Lichtfarbe entsprechen, die Kombination mehrerer Leuchtstoffe angewendet werden. Dieses Zweikomponenten-System hat prinzipiell mehrere Nachteile: Der langweiligere Leuchtstoff absorbiert i. allg. die Emission des kürzerwelligen. Des weiteren müssen die Partikelgrößen der Leuchtstoffe aufeinander abgestimmt sein, damit keine Agglomeration oder Sedimentation auftritt. Hinzu kommt, dass die Leuchtstoffe in einem exakten Mischungsverhältnis sehr homogen gemischt werden müssen, um Farbortschwankungen zu vermeiden. Schließlich zeigen die bekannten Leuchtstoffe im allgemeinen eine unterschiedliche Temperaturabhängigkeit, wodurch eine Farbortdrift beim Dimmen der LED oder unterschiedlichen Umgebungstemperaturen entstehen kann.

### Darstellung der Erfindung

Es ist Aufgabe der vorliegenden Erfindung, einen Leuchtstoff gemäß dem Oberbegriff des Anspruchs 1 bereitzustellen, der sich durch Robustheit und hohe Sensibilität für die Wahl des Farbort in einem weiten Bereich des Farbdiagramms auszeichnet
Eine weitere Aufgabe ist die Herstellung eines hocheffizienten, stabilen Grünleuchtstoffs mit Granatstruktur für den Einsatz in vollfarbtauglichen LEDs auf der Basis einer kurzwellig emittierenden, beispielsweise im Blauen emittierenden Primär-LED mit langer Lebensdauer ermöglicht.
Eine weitere Aufgabe ist die Herstellung eines hocheffizienten Granatleuchtstoffs mit genau abgestimmten Farbort für die photonische Anregung, insbesondere durch weiße LEDs, sowie die Bereitstellung einer Lichtquelle, insbesondere einer weißen LED mit neutral- bis warmweißer Lichtfarbe mit nur einem Leuchtstoff als Konverter. Bei Verwendung eines einzigen Leuchtstoffs lassen sich Farbortschwankungen einschränken und die Produktion wird einfacher, da es keine Misch- und Sedimentationsprobleme gibt. Selbstverständlich kann der Leuchtstoff auch zusammen mit anderen Leuchtstoffen für die Bereitstellung einer Lichtquelle verwendet werden.
Diese Aufgabe wird durch die kennzeichnenden Merkmale des Anspruchs 1 gelöst. Besonders vorteilhafte Ausgestaltungen finden sich in den abhängigen Ansprüchen.
Die erfindungsgemäße Substitution der Komponente B, insbesondere von Al3+, durch Si4+ führt in Leuchtstoff-Systemen mit Granatstruktur, beispielsweise Y(Al,Ga)G:Ce zu einer ausgeprägten Farbortverschiebung. Dabei ist normalerweise immer eine weitere Komponente aus Gründen der Ladungskompensation erforderlich, weil Si ein vierwertiges Ion, die Komponente B wie beispielsweise Al aber ein dreiwertiges Ion ist. Aus diesem Grund hat man bisher immer nur den naheliegenden Weg versucht, Al durch andere dreiwertige Ionen wie Ga oder In zu ersetzen, die denselben Gitterplatz belegen.
Für die Realisierung gibt es mehrere Wege. In einer ersten Ausführungsform wird gleichzeitig mit Si ein Ion KB eingeführt, das denselben Gitterplatz belegt, jedoch eine Wertigkeit unter 3 besitzt, also ein einwertiges- Ion. In diesen Fällen wird das Ersatzion KB häufig als Oxid eingeführt, so dass wegen der Granatstruktur keine weitere Ladungskompensation beachtet werden muss.

In einer zweiten Ausführungsform wird ein anderer Weg eingeschlagen, indem gleichzeitig mit Si ein Ion KC eingeführt wird, das einen anderen Gitterplatz mit entgegengesetzter Ladungspolarität belegt. Aufgrund der anderen Ladungspolarität ist in diesem Fall der Wahl der Wertigkeit keine Beschränkung auferlegt. Besonders bevorzugt ist für diesen Fall der Ersatz von Sauerstoff (als $O^{2-}$ zu verstehen) durch Stickstoff (als $N^{3-}$ zu verstehen).

In einer dritten Ausführungsform wird gleichzeitig mit Si ein Ion KA eingeführt, das einen anderen Gitterplatz, nämlich den der Komponente A, belegt. Dabei ist wieder die Ladungspolarität dieselbe wie bei Si. Geeignete Kandidaten sind Na und Li.

In einer vierten Ausführungsform wird kein weiteres Ion mit Si eingeführt, sondern die Ladungskompensation erfolgt über Fehlstellen (nach Kröger-Vink mit $V_A$ oder $V_B$ oder $V_C$ bezeichnet, wenn die Fehlstelle am Gitterplatz von A, B oder O sitzt), die mit einer eigenen Wertigkeit von null angesetzt werden.

Bevorzugt eignen sich generell Ionen, deren Radius möglichst nahe am Radius des zu ersetzenden Ions liegt. In der Praxis zeigt sich, dass im Falle eines größeren Radius diese Grenze bei 30 %, also einem 1,3 -fach höheren Radius liegt. Im Falle eines Ions, dessen Radius kleiner als der des zu ersetzenden Ions ist, ist diese Grenze deutlich weniger kritisch.

Die Substitution unter Beibehaltung der Granatstruktur hat nichts mit den neuartigen Nitridosilikaten zu tun, die zwar aus ähnlichen Einzelkomponenten aufgebaut sein können, jedoch völlig andere Stöchiometrie, Gitterstruktur und Emissionsverhalten besitzen; eine typische Gitterstruktur ist $\alpha$-Sialon, siehe "On new rare-earth doped M-Si-Al-O-N materials", van Krevel, TU Eindhoven 2000, ISBN 90-386-2711-4, Kapitel 2.

Im einzelnen zeigt sich im Falle einer gleichzeitiger Ladungskompensation durch einen Austausch von $O^{2-}$ durch $N^{3-}$ überraschenderweise eine deutlich kurzwelligere Emission als bei entsprechendem Granat mit konventionellem Teilersatz des Al durch Ga, also Y(Al,Ga)G:Ce, wie bisher in der Literatur bekannt. Dabei wird die hohe Quanteneffizienz des reinen YAG:Ce-Leuchtstoffs nahezu beibehalten. Es lassen sich beispielsweise Leuchtstoffe mit 4 mol-% Cer als Aktivator und einer Dominanzwellenlänge zwischen 559 nm und 573 nm mit einer Quanteneffizienz von ca. 85-90% synthetisieren. Ohne die Verwendung des Siliziums müsste die Cer-Dotierung sehr stark reduziert werden, um vergleichbare Dominanzwellenlängen zu erreichen. Bei 4% Cer-Dotierung wurde in der Praxis als kürzeste Dominanzwellenlänge 563 nm erreicht. Die Cer-Dotierung liegt im Bereich 0,1 bis 10 %.

Überraschenderweise wirkt die Substitution in rein Al-haltigen Granat-Leuchtstoffen vom Typ (Y,Tb,Gd)AG:Ce anders. Durch geringe Substitution (< 1 mol%) von Al durch Si in YAG:Ce lässt sich die Dominanzwellenlänge um einige Nanometer zu längeren Wellenlängen hin verschieben, ohne dass die Effizienz des Leuchtstoffs abnimmt. Dadurch ist es möglich, den Weißfarbort der Standard-Weiß-LED "optimal" einzustellen, ohne einen zweiten, in aller Regel ineffizienteren Leuchtstoff zur Farbortkorrektur einsetzen zu müssen.

Erhöht man den Siliziumgehalt auf bis zu 20 mol-%, insbesondere im Bereich 1-20 mol-%, bevorzugt bis 10 mol-%, so erhält man eine immer deutlicher erkennbare rote Cer-Emission. Die Dominanzwellenlänge verschiebt sich dadurch auf bis zu 584 nm. Es zeigt sich, dass sich unter Verwendung eines solchen Leuchtstoffs beispielsweise eine Warmweiß-LED mit Farbtemperatur von ca. 3200 K und einem Ra-Wert um 75-80 mit nur einem Leuchtstoff herstellen lässt. Die Quanteneffizienz des Leuchtstoffs steigt mit abnehmendem Si-Gehalt. Die entsprechende LED-Effizienz steigt daher mit zunehmender Farbtemperatur. Es lassen sich Lichtquellen realisieren, die im Bereich der Lichtfarben tageslichtähnlich über neutralweiß bis warmweiß liegen, insbesondere im Bereich einer Farbtemperatur 2600 bis 6500 K.

Unter Granatstruktur ist hier selbstverständlich auch eine geringfügig vom Idealfall des Granats abweichende, auf Fehlstellen oder Gitterstörungen beruhende Struktur gemeint, solange dieser Kristall die typische Granatstruktur beibehält.

Ein typischer erfindungsgemäßer Leuchtstoff hat die ideale Granatstruktur A3B5O12:D mit der neuartigen grundsätzlichen Modifikation $A_{3-u}B_{5-v}Si_xO_{12-w}$:D, dabei sitzt Si nur auf dem Gitterplatz der Komponente B, wobei Ladungsneutralität erhalten bleiben muss, beispielsweise realisiert als A3B5-xSixKyO12-y:D, mit
A = Seltenerdmetall (SE) erfindungsgemäß ausgewählt aus der Gruppe Y, Gd, La, Lu einzeln oder in Kombination oder vergleichsweise; A = Seltenerdemetall (SE) ausgewählt aus der Gruppe Y. Gd, Tb, La, Lu einzeln oder in Kombination
B = Al, Ga, In einzeln oder in Kombination;
D = Aktivator, der SE ersetzt, ausgewählt aus der Gruppe Ce, Pr, Eu einzeln oder in Kombination;
K = Ladungskompensator, insbesondere N3-, der die Ladungsfehlanpassung des Si ausgleicht.

Dabei gilt insbesondere $0 < x \leq 1$ sowie $0 \leq y \leq 2x$.

Der Wert von y hängt von den Einzelheiten des Kristallaufbaus ab, insbesondere im Falle K = N gilt y =x.

Generell ist im einzelnen zu berücksichtigen, dass verschiedene Gitterplätze verschiedene Wertigkeiten haben können, so dass eine Darstellung des modifizierten Granats unter Berücksichtigung möglicher kompensierender Komponenten KA auf dem Gitterplatz A, kompensierender Komponenten KB auf dem Gitterplatz B und kompensierender Komponenten KC auf dem Gitterplatz des Sauerstoffs zur generellen Darstellung

$[A_{3-a}KA_a]_A\ [B_{5-b-x}KB_bSi_x]_B\ [O_{12-s}KC_s]_o$:D führt, wobei der Aktivator D der Komponente A zuzurechnen ist. In anderen Worten kann also die Formel auch ausgedrückt werden als $[A_{3-t-a\#}KA_{a\#}D_t]_A[B_{5-b-x}KB_bSi_x]_B[O_{12-s}KC_s]_o$. Dabei ist a# ein anderer Wert als a, der sich ausgehnd von a durch Zurechnung der Dotierung D ergibt, wie an sich bekannt.

Die wesentliche Bedingung für die Koeffizienten ist allgemein darstellbar als:

$$a(m_{KA}-3) + b(m_{KB} - 3) + x = s(-m_{KC} - 2).$$

Dabei ist m die jeweilige Wertigkeit des eingebauten Ions der Komponente KA, KB oder KC, wobei die etwaigen Fehlstellen mit einer Wertigkeit m=0 angesetzt sind.

Dabei gibt es mehrere grundsätzliche Ausführungsformen:

Zum ersten gibt es den Typ, bei dem Si einen Teil des Elements B ersetzt, wobei Si durch eine Fähre, nämlich einen Sauerstoff ersetzenden Mechanismus, beispielsweise mittels Stickstoff, eingebracht wird, so dass für die Stöchiometrie gilt: $A_3B_{5-x}Si_x[O_{12-s}N_s]_o$:D, wobei der tiefgestellte Index O eine Aussage über den Gitterplatz O macht. Hier ist N ein Ion des Typs KC, wobei insbesondere s ≤1,5 und x ≤ 1,5, und bevorzugt x=s.

Zum zweiten gibt es den Typ, bei dem Si das Element B teilweise ersetzt, wobei Si durch einen die Ladung am Gitterplatz B ausgleichenden Mechanismus eingebracht wird, so dass für die Stöchiometrie gilt: $A_3[B_{5-(x+y)}Si_xKB_y]_BO_{12}$:D, wobei der tiefgestellte Index B eine Aussage über den Gitterplatz B macht. Beispielsweise wird Si zusammen mit Na eingebracht, und zwar beide über eine Sauerstoffverbindung als Fähre, wobei insbesondere y ≤1 und x ≤ 1.

Im Falle eines anderen Einbringens der Kodotierung K, beispielsweise mittels Stickstoff oder eines anderen Sauerstoff ersetzenden Elements, ergibt die resultierende Stöchiometrie Vergleichsbeispiels eine Mischform zum ersten Typ, also beispielsweise

$$A_3[B_{5-x-y}Si_xKB_y]_B[O_{12-s}N_s]_o:D.$$

Ein Beispiel ist x =1 und y =0,5 mit B ist Mg2+ sowie s = 0,5.

Zum dritten den Typ, bei dem Si das Element B teilweise ersetzt, wobei Si durch ein Element als Fähre eingebracht wird, das den Gitterplatz A teilweise ersetzt, also durch einen A ersetzenden Mechanismus eingebracht wird, so dass für die Stöchiometrie gilt:

$$[A_{3-y}KA_y]_A[B_{5-x}Si_x]_BO_{12}:D,$$

wobei der tiefgestellte Index A, B eine Aussage über die Zugehörigkeit zu den Gitterplätzen der Komponente A und B macht. Hier ist insbesondere x = y. Als KA kommen Na und Li in Frage, die einwertig eingebaut werden, wobei insbesondere y ≤ 2 und x ≤ 2.

Zum vierten gibt es den Typ, der den Ladungsausgleich allein durch Fehlstellenbildung kompensiert. In diesem Fall kann das Si mit Fehlstellen an allen Gitterplätzen einhergehen. Die Stöchiometrie ist dann: $A_{3-x/3}B_{5-x}Si_xO_{12}$:D, wobei insbesondere x ≤ 0,2. Beispielsweise ist x = 0,1.

Selbstverständlich können auch Mischformen all dieser Grundtypen auftreten. Die Dotierung D ist normalerweise immer als Bestandteil des Gitterplatzes A aufzufassen.

Bevorzugt ist im Falle B = Al der Wert x zwischen 0,01 ≤ x ≤ 1, bevorzugt ist im Falle B = (Al, Ga) mit einem Ga-Anteil von mindestens 20 mol-% von B der Wert von x im Bereih 0,05 ≤ x ≤ 0,25. Je nach Umgebung wirkt der Zusatz von Si in der Granatstruktur rot- oder blau-verschiebend gegenüber einem gleichartigen Si-freien Granat. Noch überraschender ist der Befund, dass die Größe der Farbortverschiebung nicht eine eindeutige Funktion der Beigabe an Si ist, sondern sich eher im Sinne einer Relation verhält. Besonders große Verschiebungen lassen sich mit eher geringen Beimengungen an Si erreichen (x = 0,08 bis 0,23). Das Verhalten im Einzelfall hängt zudem aber noch von dem Ladungskompensator K ab, insbesondere der Frage seines zugeordneten Gitterplatzes.

Der Ionenradius des Si4+ ist vergleichbar groß wie der des Al3+, so dass es relativ leicht anstatt Al3+ eingebaut werden kann. Dies ist einer der wesentlichen Punkte für das überraschend gute Funktionieren des Ersetzens. Dagegen ist der Ionenradius des Mg2+, das hier als vergleichsweise als Ladungskompensator dienen kann, merklich größer als von Al3+, so dass es weniger gut anstatt Al3+ eingebaut werden kann. Daher kann mit dem System Si4+-Mg2+ nur eine relativ kleine Menge an Si4+ zugesetzt werden.

Dagegen ist das System Si4+ mit N3- als Ladungskompensator deutlich weniger kritisch, weil das Stickstoff-Ion das etwa gleich große Sauerstoff-Ion ersetzt. Daher kann mit diesem System eine relativ große Menge an Si4+ zugesetzt werden.

Vorteilhaft ist, dass dieser Mechanismus teilweise auch die Rolle des Aktivators D hinsichtlich einer Verschiebung des Farborts übernehmen kann, so dass relativ geringe Mengen an D, verglichen mit konventionellen Granaten, benötigt werden. Dies gilt insbesondere im Falle D = Ce.

Die Anregbarkeit der neuartigen Leuchtstoffe erstreckt sich zudem über einen weiten Bereich, der von etwa 250 nm, bevorzugt 300 nm, bis zu etwa 550 nm, bevorzugt 490 m, reicht. Maxima liegen bei etwa 350 nm und etwa 460 m. Damit ist dieser Leuchtstoff nicht nur zur Anregung durch UV oder blau emittierende Primärlichtquellen wie LEDs oder konventionelle Entladungslampen auf Hg-Basis geeignet, sondern auch für Lichtquellen wie einer Entladungslampe auf Basis einer Indium-Niederdruckentladung oder auch Indium-Hochdruckentladung, deren Resonanzlinien beispielsweise bei 304, 325, 410 und 451 nm liegen.

Das Emissionsverhalten hängt deutlich vom Ladungskompensator ab. Beispielsweise führt die Verwendung von Stickstoff zu einem erhöhten kovalenten Bindungsanteil, in der Literatur wird so ein Verhalten als sog. nephelauxetischer Effekt beschrieben. Dem kann gleichzeitig eine erhöhte Kristallfeldaufspaltung überlagert sein, bedingt beispielsweise durch die höhere Ladung des $N^{3-}$Ions gegenüber dem $O^{2-}$ -Ion. Das gegenüber Al3+ höher geladene Si4+-Ion beeinflusst diese Effekte zusätzlich, die Zielrichtung hängt hier von den Details ab.

Der erfindungsgemäße Leuchtstoff eignet sich hervorragend als Grün-Leuchtstoff.

Ein besonderer Vorteil der erfindungsgemäßen Leuchtstoffe ist, dass sie relativ wenig Temperaturlöschung zeigen. Überraschend ist, dass ein vierwertiges Ion wie Si ohne nennenswerte Effizienzverluste auf den Gitterplatz eines dreiwertigen Ions eingebaut werden kann.

## Kurze Beschreibung der Zeichnungen

Im folgenden soll die Erfindung anhand mehrerer Ausführungsbeispiele näher erläutert werden. Es zeigen:

| | |
|---|---|
| Figur 1 | ein Halbleiterbauelement, das als Lichtquelle (LED) für weißes oder grünes Licht dient; |
| Figur 2 | eine Beleuchtungseinheit mit Leuchtstoffen gemäß der vorliegenden Erfindung; |
| Figur 3 | das Emissionsspektrum einer warmweißen LED mit Si-Granat; |
| Figur 4 | das Reflexionsverhalten eines Si-Granats; |
| Figur 5 | das Emissionsverhalten eines Si-Granats; |
| Figur 6 | das Emissionsverhalten eines weiteren Si-Granats; |
| Figur 7 | das Emissionsverhalten eines weiteren Si-Granats; |
| Figur 8 | die Verschiebung der dominanten Wellenlänge eines Si-Granats; |
| Figur 9 | ein Spektrum einer LED-Lampe |
| Figur 10 | ein Spektrum einer LED-Lampe |
| Figur 11 | ein Spektrum einer LED-Lampe |
| Figur 12 | die Verschiebung der dominanten Wellenlänge eines Si-Granats; |
| Figur 13 | das Farbdiagramm für ein System blaue Primär-LED mit Si-Granat; |
| Figur 14-17 | ein Röntgendiffraktogramm für verschiedene Si-Granate; |
| Figur 18 | ein Beispiel einer OLED; |
| Figur 19 | eine Niederdrucklampe mit Indium-Füllung unter Verwendung eines Granats; |
| Figur 20 | die Langzeitstabilität einer warmweißen LED. |

## Bevorzugte Ausführung der Erfindung

Für den Einsatz in einer warmweißen LED zusammen mit einem GaInN-Chip wird beispielsweise ein Aufbau ähnlich wie in US 5 998 925 beschrieben verwendet. Der Aufbau einer derartigen Lichtquelle für weißes Licht ist in Figur 1 explizit gezeigt. Die Lichtquelle ist ein Halbleiterbauelement (Chip 1) des Typs InGaN mit einer Peak-Emissionswellenlänge von 460 nm mit einem ersten und zweiten elektrischen Anschluss 2,3, das in ein lichtundurchlässiges Grundgehäuse 8 im Bereich einer Ausnehmung 9 eingebettet ist. Einer der Anschlüsse 3 ist über einen Bonddraht 14 mit dem Chip 1 verbunden. Die Ausnehmung hat eine Wand 17, die als Reflektor für die Primärstrahlung des Chips 1 dient. Die Ausnehmung 9 ist mit einer Vergussmasse 5 gefüllt, die als Hauptbestandteile ein Epoxidgießharz (beispielsweise 80 bis 90 Gew.-%) und Leuchtstoffpigmente 6 (beispielsweise weniger als 15 Gew.-%) enthält. Weitere geringe Anteile entfallen u.a. auf Aerosil. Die Leuchtstoffpigmente bestehen aus Pigmenten von Siliziumhaltigem Granat. Diese emittieren gelb und mischen sich zusammen mit einem Rest des nicht konvertierten Blau der Primärstrahlung zu weiß. Der gleiche Aufbau eignet sich auch zur Schaffung einer grün emittierenden LED, wobei die blaue Primärstrahlung vollständig konvertiert wird.

In Figur 2 ist ein Ausschnitt aus einer Flächenleuchte 20 als Beleuchtungseinheit gezeigt. Sie besteht aus einem gemeinsamen Träger 21, auf den ein quaderförmiges äußeres Gehäuse 22 aufgeklebt ist. Seine Oberseite ist mit einer gemeinsamen Abdeckung 23 versehen. Das quaderförmige Gehäuse besitzt Aussparungen, in denen einzelne Halbleiter-Bauelemente 24 untergebracht sind. Sie sind UVemittierende Leuchtdioden mit einer Peakemission von typisch 340 nm. Die Umwandlung in weißes Licht erfolgt mittels Konversionsschichten, die direkt im Gießharz der einzelnen LED sitzen ähnlich wie in Figur 1 beschrieben oder Schichten 25, die auf allen der UV-Strahlung zugänglichen Flächen angebracht sind. Dazu zählen die innen liegenden Oberflächen der Seitenwände des Gehäuses, der Abdeckung und des Bodenteils. Die Konversionsschichten 25 bestehen aus drei Leuchtstoffen, die im roten, grünen und blauen Spektralbereich emittieren unter Benutzung der erfindungsgemäßen Leuchtstoffe.

Tab. 1 zeigt zunächst Ionenradien einiger wichtiger Elemente, die im Granat eingebaut werden. Die relativen Quanteneffizienzen QE einiger Si-Granate des Typs Y(Al3-xSixGa2)O12:Ce(4 %) sind in Tab. 2 gezeigt.

Figur 3 zeigt das Emissionsspektrum einer warmweißen LED, die einen einzigen Si-Granat als Konversionsmittel verwendet. Die Primärstrahlung ist 460 nm, womit eine Farbtemperatur von 3250 K und ein Farbwiedergabeindex von 80 erzielt wird.

Fig. 4 zeigt das Reflexionsverhalten eines Si-Granats als Funktion der Wellenlänge. Es handelt sich um Y3Al4,9Si0,1O11,9N0,1:Ce.

Figur 5 zeigt als Funktion der Wellenlänge (in nm) das Emissionsverhalten eines Si-Granats (x=0,25), nämlich Y3Al4,75Si0,251O11,75N0,25:Ce im direkten Vergleich mit dem Emissionsverhalten des gleichen Granats ohne Si-Zusatz (x=0) , nämlich YAG:Ce. Erstaunlich ist die sehr große Verschiebung der Peakwellenlänge. Ein typischer Wert für die Cer-Dotierung ist 0,5 bis 4 % von A.

Figur 6 zeigt das Emissionsverhalten des Si-Granats Tb(Al4,5Si0,5)O11,5N0,5:Ce als Funktion der Wellenlänge. Figur 7 zeigt das Emissionsverhalten des Si-Granats (Y0,55Gd0,45)(Al4,5Si0,5)O11,5N0,5:Ce als Funktion der Wellenlänge.

Figur 8 zeigt die Verschiebung der dominanten Wellenlänge (nm) als Funktion des Gehalts x an Si bei 460 m für den Leuchtstoff Y(Al5-xSix)(O12-xNx):Ce. Überraschend ist das Maximum bei etwa 0,25. Es liegt also keine lineare Funktion vor.

Figur 9 zeigt die Änderung der Effizienz und Emissionsbreite für verschiedene Leuchtstoffe des Typs Y2,88Ce0,12Al5O12 (also YAG:Ce) bei Austausch von AlO durch SiN.

Figur 10 zeigt die Änderung der Effizienz und Emissionsbreite für verschiedene Leuchtstoffe des Typs Y2,88Ce0,12Al3Ga2O12 (also Y(Al,Ga)G:Ce) bei Zugabe von Si als SiN im Austausch zu AlO. Überraschend verhält sich dieses System infolge der Galliumzugabe völlig anders als reines YAG:Ce.

Figur 11 zeigt als Funktion der Wellenlänge (in nm) das Emissionsverhalten eines Si-Granats (x=0,25), im direkten Vergleich mit dem Emissionsverhalten des gleichen Granats ohne Si-Zusatz (x=0) , nämlich Y3Al2Ga2:Ce . Erstaunlich ist nicht nur die große Verschiebung der Peakwellenlänge, sondern auch die Tatsache, dass sie genau in die entgegengesetzte Richtung wie in Figur 5 erfolgt. Die Details dieses ungewöhnlichen Verhaltens sind noch nicht vollständig verstanden.

Figur 12 zeigt die Verschiebung der dominanten Wellenlänge (nm) als Funktion des Gehalts x an Si bei 460 nm Anregung für den Leuchtstoff Y(Al3-xGa2Six)O12:Ce. Überraschend ist das Maximum bei etwa 0,25. es liegt also keine lineare Funktion vor.

Figur 13 zeigt das Farbdiagramm (CIE) mit den Koordinaten x, y für ein System aus blauer LED (Peakemission bei 450 bis 470 nm) und erfindungsgemäßen Si-Granaten. Es zeigt sich dass bei konventionellen Granaten nun erstmals Systeme mit warmweißer Lichtfarbe von typisch 3200 oder 2850 K oder darunter leicht mit einem einzigen Leuchtstoff realisiert werden können. Kandidaten dafür sind insbesondere Si-Granate auf Basis der Granate (Hohle Dreiecke) der Seltenerdmetalle Y, Tb und Gd, die mittels Si-Zugabe nach rechts zu längeren Wellenlängen hin verschoben werden können (gefüllte Dreiecke). Umgekehrt lassen sich gut grüne LEDs realisieren, indem Ga-haltige Granate (Al:Ga Verhältnis ist bevorzugt zwischen 0,5 und 2,5), ausgehend von YAG:Ce, mit Si beaufschlagt werden, wobei die Peakwellenlänge nach links zu kürzeren Wellenlängen hin wandert.

Si-Granate sind daher ideal zur maßgeschneiderten Anpassung an Kundenwünsche geeignet.

Figur 14 zeigt ein Röntgendiffraktogramm für YAG:Ce mit Si-Anteil x=0,1, das die typische Granatstruktur, verglichen mit konventionellem YAG:Ce , siehe untere Laufleiste, verdeutlicht. Figur 15 zeigt ähnliches für einen Si-Anteil von x = 0,25.

Figur 16 zeigt ein Röntgendiffraktogramm für YAl3Ga2O12:Ce mit Si-Anteil x=0,25, das die typische Granatstruktur, verglichen mit konventionellem YAG:Ce , siehe untere Laufleiste, verdeutlicht, wobei als zweite Laufleiste ein Yttriumoxinitrid angegeben ist, dessen Struktur aber nicht für den untersuchten Leuchtstoff passt. Figur 17 zeigt ähnliches für einen Si-Anteil von x = 0,5.

Ein typisches Herstellverfahren orientiert sich grundsätzlich an der üblichen Herstellung von YAG:Ce mit folgender beispielhafter Modifikation:

Der Ansatz wird entsprechend Tab. 3 wie folgt gewählt:

Dieser Ansatz wird ca. 40 min in einer Mörsermühle gemischt; anschließend wird er bei 1460 - 1560 °C für mehrere Stunden (typisch 3 h) geglüht. Die genaue Temperatur ist abhängig von der Zusammensetzung und vor allem von der Schmelzmittelzugabe. Typisch ist die Zugabe von Borsäure H3BO3.

Figur 18 zeigt eine weitere Anwendung, wie sie im Prinzip bereits aus US-B 6 700 322 bekannt ist. Dabei wird der erfindungsgemäße Leuchtstoff zusammen mit einer OLED angewendet. Die Lichtquelle ist eine organische lichtemittierende Diode 31, bestehend aus der eigentlichen organischen Folie 30 und einem transparenten Substrat 32. Die Folie 30 emittiert insbesondere blaues primäres Licht, erzeugt beispielsweise mittels PVK:PBD:Kumarin. Die Emission wird von einer Deckschicht, gebildet aus einer Schicht 33 des erfindungsgemäßen Leuchtstoffs, teilweise in gelbes, sekundär emittiertes Licht umgewandelt, so dass insgesamt durch Farbmischung des primär und sekundär emittierten Lichts eine weiße Emission realisiert wird. Bevorzugt ist das Zusammenwirken des erfindungsgemäß en Leuchtstoffs mit einer blaugrünen Primäremission. Das bedeutet, die primäre Emission liegt bei 480 bis 505 nm Peakwellenlänge. Sie kann besonders bevorzugt auch realisiert sein durch eine organische Leuchtstofffolie, die zwei Peaks, einen im blauen bei 430 bis 490 nm und einen weiteren bei 495 bis 520 m, so dass insgesamt die dominante Wellenlänge bei blaugrün liegt. Dieses System erreicht mit nur zwei Leuchtstoffen (die Folie und der modifizierte Granat-Leuchtstoff) erstaunliche Werte der Farbwiedergabe (Ra besser als 85) bei einer Farbtemperatur von 4000 K bis 4600 K. Die OLED besteht im wesentlichen aus mindestens einer Schicht eines lichtemittierenden Polymers oder von sog. small molecules zwischen zwei Elektroden, die aus an sich bekannten Materialien bestehen, wie beispielsweise ITO als Anode, und ein hochreaktives Metall, wie z.B. Ba oder Ca, als Kathode. Oft werden auch mehrere Schichten zwischen den Elektroden verwendet, die entweder als Lochtransportschicht dienen (z.B. Baytron-P, kommerziell von HC Starck erhältlich) oder im Bereich der Small Molecules auch als Elektronentransportschichten dienen. Als emittierende Polymere kommen beispielsweise Polyfluorene oder Polyspiro-Materialien zum Einsatz.

Eine weitere Anwendung des erfindungsgemäß en Leuchtstoffs ist bei LeuchtstoffLampen, wo er auf die Innenseite des Kolbens aufgetragen wird, wie an sich bekannt, evtl. in Verbindung mit weiteren an sich bekannten Leuchtstoffen wie beispielsweise Halophosphaten. Die Anregung erfolgt dabei über die bekannten Hg-Linien, insbesondere bei 254 nm.

Eine spezielle Anwendung ist in einer Indiumlampe. Figur 19 zeigt eine Niederdruck-Entladungslampe 20 mit einer quecksilberfreien Gasfüllung 21 (schematisiert), die eine Indiumverbindung und ein Puffergas analog WO 02/10374 enthält, wobei eine Schicht 22 aus Si-haltigem Granat angebracht ist. Der ganz besondere Vorteil bei dieser Anordnung ist, dass dieser modifizierte Granat gut der Indium-Strahlung angepasst ist, weil diese wesentliche Anteile sowohl im UV als auch im blauen Spektralbereich hat, die von diesem Granat beide gleichermaßen gut absorbiert werden, was ihn bei dieser Verwendung gegen die bisher bekannten Leuchtstoffe überlegen macht. Diese bekannten Leuchtstoffe absorbieren nennenswert entweder nur die UV-Strahlung oder die blaue Strahlung des Indiums, so dass die erfindungsgemäße Indium-Lampe eine deutlich höhere Effizienz zeigt. Diese Aussage gilt auch für eine Indium-Lampe auf Hochdruck-Basis wie an sich aus US 4 810 938 bekannt.

Eine weitere Anwendung ist die Anregung in elektrolumineszenten Lampen durch einen blau oder blaugrün emittierenden elektrolumineszenten Leuchtstoff mit Peakemission zwischen 440 und 520 nm.

Figur 20 zeigt die gute Langzeit-Stabilität einer warmweißen LED unter Verwendung des in Figur 3 diskutierten Leuchtstoffs. Sowohl der Lichstrom (Figur 20a) als auch die Farbkoordinaten x und y (Figur 20b, 20c) bleiben über 500 Std. nahezu stabil.

Tab. 1 Ionenradien (typischer Wert) in nm

| | CN4 tetraedrisch | CN6 oktaedrisch |
|---|---|---|
| Mg2+ | - | 0,07 |
| Al3+ | 0,04 | 0,05 |
| Ga3+ | 0,05 | 0,06 |
| Si4+ | 0,04 | 0,05 |
| O2- | 0,12 | 0,13 |
| N3- | 0,13 | 0,17 |

Tab. 2 relative Quanteneffizienz für YAG:Ce, bei dem A ersetzt ist durch (Al3-xSixGa2) bei 460 nm Anregung

| X (Si) | Rel. QE in % | Dom. Wellenlänge (nm) |
|---|---|---|
| 0 | 100 | 566 |
| 0,25 | 101 | 559 |
| 0,50 | 103 | 560 |
| 0,75 | 100 | 561 |

Tab. 3

| Komponente | Reinheit | Bezugsquelle |
|---|---|---|
| Y2O3 | 4N | Rhodia |
| CeO2 | 3N5 | Rhodia |
| Al2O3 | 4N | Alfa A |
| Ga2O3 | 5N | Alfa A |
| SiO2 | Aerosil | Ox 50 |
| H3BO3 | | Merck |

**Patentansprüche**

1. Leuchtstoff mit Granatstruktur des Typs $A_3B_5O_{12}$:D, wobei ein Teil der Komponente B durch Si mit einem Anteil von x ersetzt ist, **dadurch gekennzeichnet, dass** zum Ladungsausgleich eine Fehlstelle dient oder mindestens eine weitere Komponente K eingebaut ist, wobei A = Seltenerdmetall ausgewählt aus der Gruppe A = Y, Gd, La, Lu allein oder in Kombination und B = Al, Ga allein oder in Kombination, sowie D =Seltenerdmetall ausgewählt aus der Gruppe D = Ce, Pr, Eu allein oder in Kombination, wobei als Ladungskompensator K eines oder mehrere der Elemente N oder Na oder Li fungiert.

2. Leuchtstoff nach Anspruch 1, **dadurch gekennzeichnet, dass** $x \leq 1$.

3. Leuchtstoff nach Anspruch 1, **dadurch gekennzeichnet, dass** der Granat die folgende Struktur besitzt, wobei die Ladungskompensatoren KA, KB, KC am Gitterplatz A, B und/oder O sitzen können, wobei m die Wertigkeit der eingebauten Ionen ist:

$$[A_{3-a}KA_a]A\ [B_{5-b-x}KB_bSi_x]_B\ [O_{12-s}KC_s]_o:D,$$

wobei gilt:

$a(m_{KA}-3) + b(m_{KB} - 3) + x = s(-m_{KC} - 2)$ und wobei als Ladungskompensatoren KA, KB, KC eines oder mehrere der Elemente N oder oder Na oder Li fungieren.

4. Leuchtstoff nach Anspruch 3 **dadurch gekennzeichnet**, dass_der Leuchtstoff die Stöchiometrie A3B5-xSixKyO12-y:D besitzt, mit $y \leq 2x$.

5. Leuchtstoff nach Anspruch 1, **dadurch gekennzeichnet, dass** x = 0,1 bis 0,5.

6. Leuchtstoff nach Anspruch 3, **dadurch gekennzeichnet, dass** KC = N und x = s.

7. Leuchtstoff nach Anspruch 3, **dadurch gekennzeichnet, dass** der Granat die folgende Struktur besitzt: $A_3B_{5-x}Si_x[O_{12-s}N_s]_o$:D, wobei insbesondere $s \leq 1{,}5$ und $x \leq 1{,}5$, und bevorzugt x=s.

8. Leuchtstoff nach Anspruch 3, **dadurch gekennzeichnet, dass** der Granat die folgende Struktur besitzt: $A_3[B_{5^-(x+y)}Si_xKB_y]_BO_{12}$:D, wobei insbesondere $y \leq 1$ und $x \leq 1$.

9. Leuchtstoff nach Anspruch 3, **dadurch gekennzeichnet, dass** der Granat die folgende Struktur besitzt: $[A_{3-y}KA_y]_A[B_{5-x}Si_x]_BO_{12}$:D, wobei insbesondere $y \leq 2$ und $x \leq 2$.

10. Leuchtstoff nach Anspruch 3, **dadurch gekennzeichnet, dass** der Granat die folgende Struktur besitzt: $A_{3-x/3}B_{5-x}Si_xO_{12}$:D, wobei insbesondere $x \leq 0{,}2$.

11. Lichtquelle mit einem Leuchtstoff nach Anspruch 1, wobei die Primäremission der Lichtquelle zur Anregung des Leuchtstoffs dient und ein Maximum der Primäremission im Bereich 250 bis 550 nm liegt, und wobei die Primärstrahlung zumindest teilweise in Sekundärstrahlung umgewandelt wird, insbesondere um weißes Licht zu erzeugen.

12. Lichtquelle nach Anspruch 11, **dadurch gekennzeichnet, dass** die Lichtquelle eine LED oder OLED oder Entladungslampe ist.

## Claims

1. Phosphor with a garnet structure of type $A_3B_5O_{12}$:D, wherein part of component B is replaced by Si in a proportion x, **characterized in that**, for charge compensation, a vacancy is used or at least one further component K is incorporated where A = rare earth selected from the group consisting of A = Y, Gd, La, Lu, alone or in combination and B = Al, Ga alone or in combination, and D = rare earth selected from the group consisting of D = Ce, Pr, Eu, alone or in combination, wherein one or more of the elements N or Na or Li functions as charge compensator K.

2. Phosphor according to Claim 1, **characterized in that** $x \leq 1$.

3. Phosphor according to Claim 1, **characterized in that** the garnet has the following structure, in which the charge compensators KA, KB, KC may be located at lattice site A, B and/or O and m is the valence of the incorporated ions:

$$[A_{3-a}KA_a]_A\ [B_{s-b-x}KB_bSi_x]_B\ [O_{12-s}KC_s]_o:D,$$

in which the following relationship applies:

$a(m_{KA-}3)+b(m_{KB}-3) + x = s\ (-m_{KC}-2)$ and in which one or more of the elements N or Na or Li function as charge compensators KA, KB, KC.

4. Phosphor according to Claim 3, **characterized in that** the phosphor has the stoichiometry A3B5-xSixKyO12-y:D, with $y \leq 2x$.

5. Phosphor according to Claim 1, **characterized in that** x = 0.1 to 0.5.

6. Phosphor according to Claim 3, **characterized in that** KC = N and x = s.

7. Phosphor according to Claim 3, **characterized in that** the garnet has the following structure: $A_3B_{5-x}Si_x[O_{12-s}N_s]_o$:D, in which in particular $s \leq 1.5$ and $x \leq 1.5$, and preferably x = s.

8. Phosphor according to Claim 3, **characterized in that** the garnet has the following structure: $A_3[B_{5-(x+y)}Si_xKB_y]_BO_{12}$:D, in which in particular $y \leq 1$ and $x \leq 1$.

9. Phosphor according to Claim 3, **characterized in that** the garnet has the following structure: $[A_{3-y}KA_y]_A[B_{5-x}Si_x]_BO_{12}$:D, in which in particular $y \leq 2$ and $x \leq 2$.

10. Phosphor according to Claim 3, **characterized in that** the garnet has the following structure: $A_{3-x/3}B_{5-x}Si_xO_{12}$: D, in which in particular $x \leq 0.2$.

11. Light source comprising a phosphor according to Claim 1, in which the primary emission of the light source serves to excite the phosphor and a maximum of the primary emission is in the range from 250 to 550 nm, and in which the primary radiation is at least partially converted into secondary radiation, in particular in order to generate white light.

12. Light source according to Claim 11, **characterized in that** the light source is an LED or OLED or discharge lamp.

## Revendications

1. Substance luminescente ayant une structure de grenat du type $A_3B_5O_{12}$:D, une partie de la composante B étant remplacée par du Si avec une part de x, **caractérisée en ce que** la compensation de la charge est effectuée par un point de défaut ou par au moins une composante K intégrée supplémentaire, A étant un métal de terres rares choisi dans le groupe A = Y, Gd, La, Lu seul ou en combinaison et B = Al, Ga seul ou en combinaison, et D étant lui aussi un métal de terres rares choisi dans le groupe D = Ce, Pr, Eu seul ou en combinaison, un ou plusieurs des éléments N ou Na ou Li faisant office de compensateur de charge K.

**2.** Substance luminescente selon la revendication 1, **caractérisée en ce que** $x \leq 1$.

**3.** Substance luminescente selon la revendication 1, **caractérisée en ce que** le grenat possède la structure suivante, les compensateurs de charge KA, KB, KC pouvant reposer à la position de grille A, B et/ou O, m étant la valence des ions incorporés : $[A_{3-a}KA_a]_A\ [B_{5-b-x}KB_bSi_x]_B\ [O_{12}-_sKC_s]_o$:D, avec :

a $(m_{KA}$-3) +b $(m_{Ks}$ - 3) + x = s $(-m_{Kc}$ - 2) et un ou plusieurs des éléments N ou Na ou Li faisant office de compensateurs de charge KA, KB, KC.

**4.** Substance luminescente selon la revendication 3, **caractérisée en ce que** la substance luminescente possède la stoechiométrie A3B5-xSixKyO12-y:D, avec $y \leq 2x$.

**5.** Substance luminescente selon la revendication 1, **caractérisée en ce que** x = 0,1 à 0,5.

**6.** Substance luminescente selon la revendication 3, **caractérisée en ce que** KC = N et x = s.

**7.** Substance luminescente selon la revendication 3, **caractérisée en ce que** le grenat possède la structure suivante : $A_3B_{5-x}Si_x[O_{12-s}N_s]_o$:D, avec notamment $s \leq 1{,}5$ et $x \leq 1{,}5$, et de préférence x = s.

**8.** Substance luminescente selon la revendication 3, **caractérisée en ce que** le grenat possède la structure suivante : $A_3[B_{5-(x+y)}Si_xKB_y]_BO_{12}$:D, avec notamment $y \leq 1$ et $x \leq 1$.

**9.** Substance luminescente selon la revendication 3, **caractérisée en ce que** le grenat possède la structure suivante : $[A_{3-y}Ka_y]_A[B_{5-x}Si_x]O_{12}$:D, avec notamment $y \leq 2$ et $x \leq 2$.

**10.** Substance luminescente selon la revendication 3, **caractérisée en ce que** le grenat possède la structure suivante : $A_{3-x/3}B_{5-x}Si_xO_{12}$:D, avec notamment $x \leq 0{,}2$.

**11.** Source de lumière comprenant une substance luminescente selon la revendication 1, l'émission primaire de la source de lumière servant à l'excitation de la substance luminescente et un maximum de l'émission primaire se trouvant dans la plage de 250 à 550 nm, et le rayonnement primaire étant au moins partiellement converti en rayonnement secondaire, notamment en vue de générer de la lumière blanche.

**12.** Source de lumière selon la revendication 11, **caractérisée en ce que** la source de lumière est une LED ou une OLED ou une lampe à décharge.

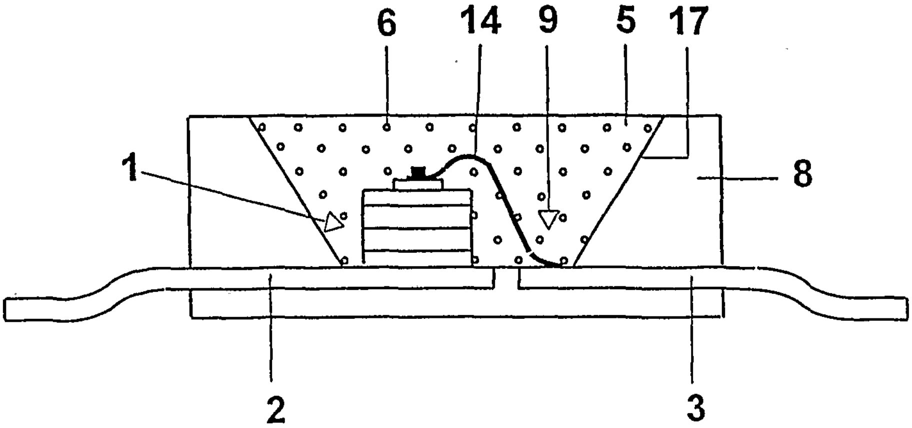


FIG. 1

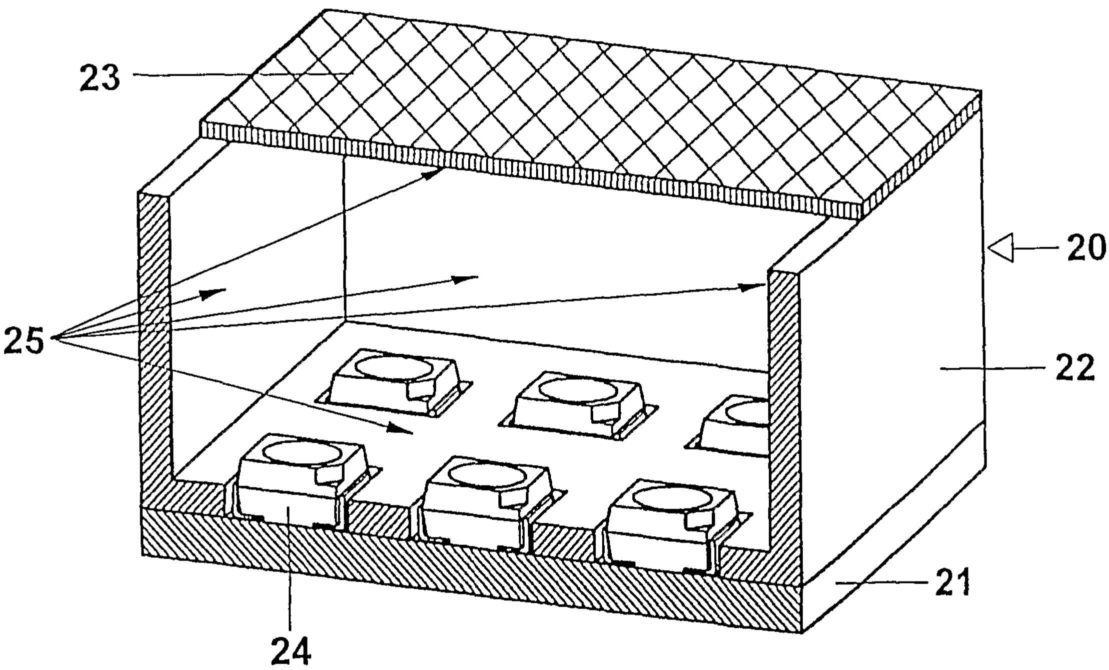


FIG. 2

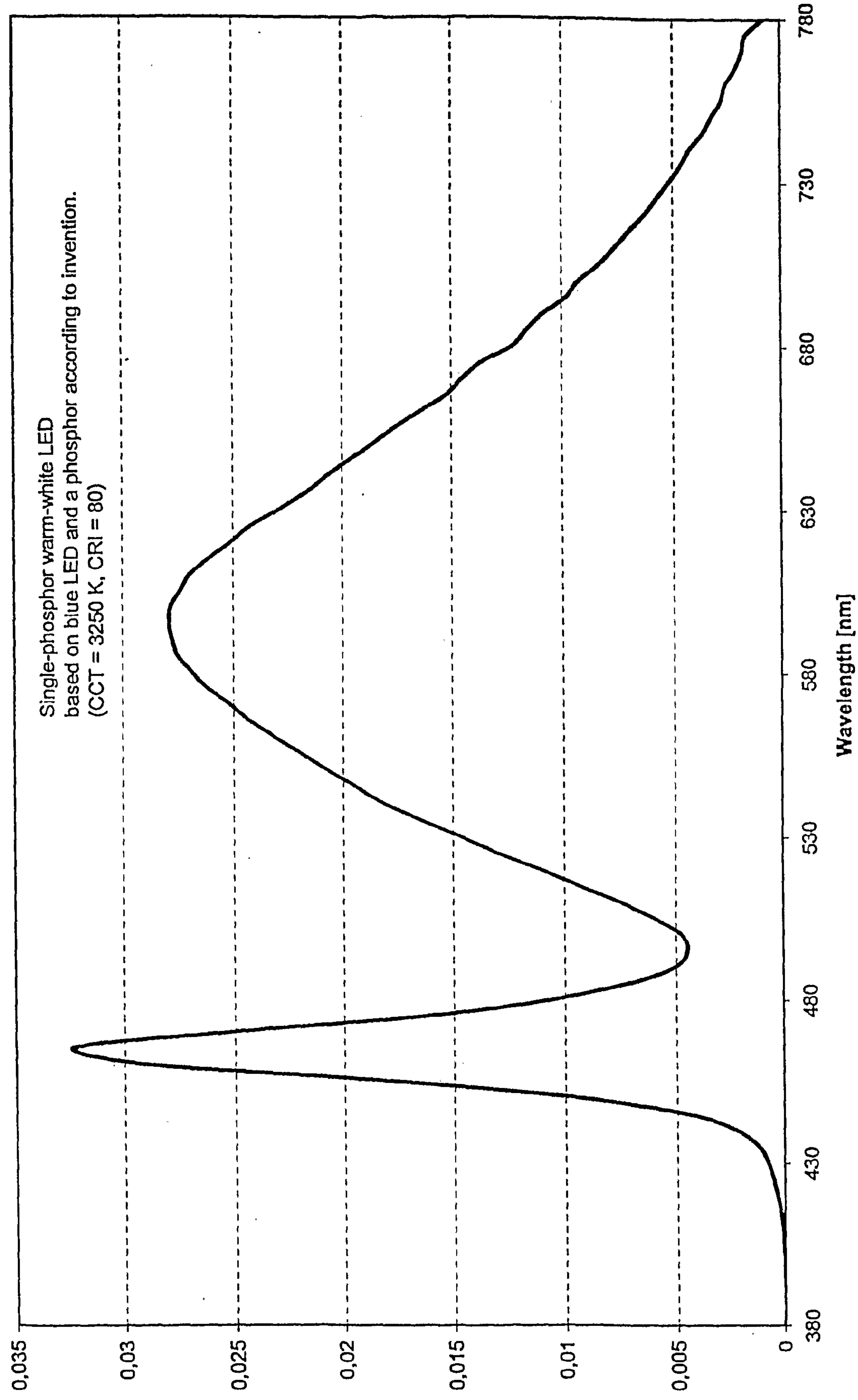
Single-phosphor warm-white LED
based on blue LED and a phosphor according to invention.
(CCT = 3250 K, CRI = 80)
Intensity [a.u.]
0,035
0,03
0,025
0,02
0,015
0,01
0,005
0
380
430
480
530
580
630
680
730
780
Wavelength [nm]

FIG. 3

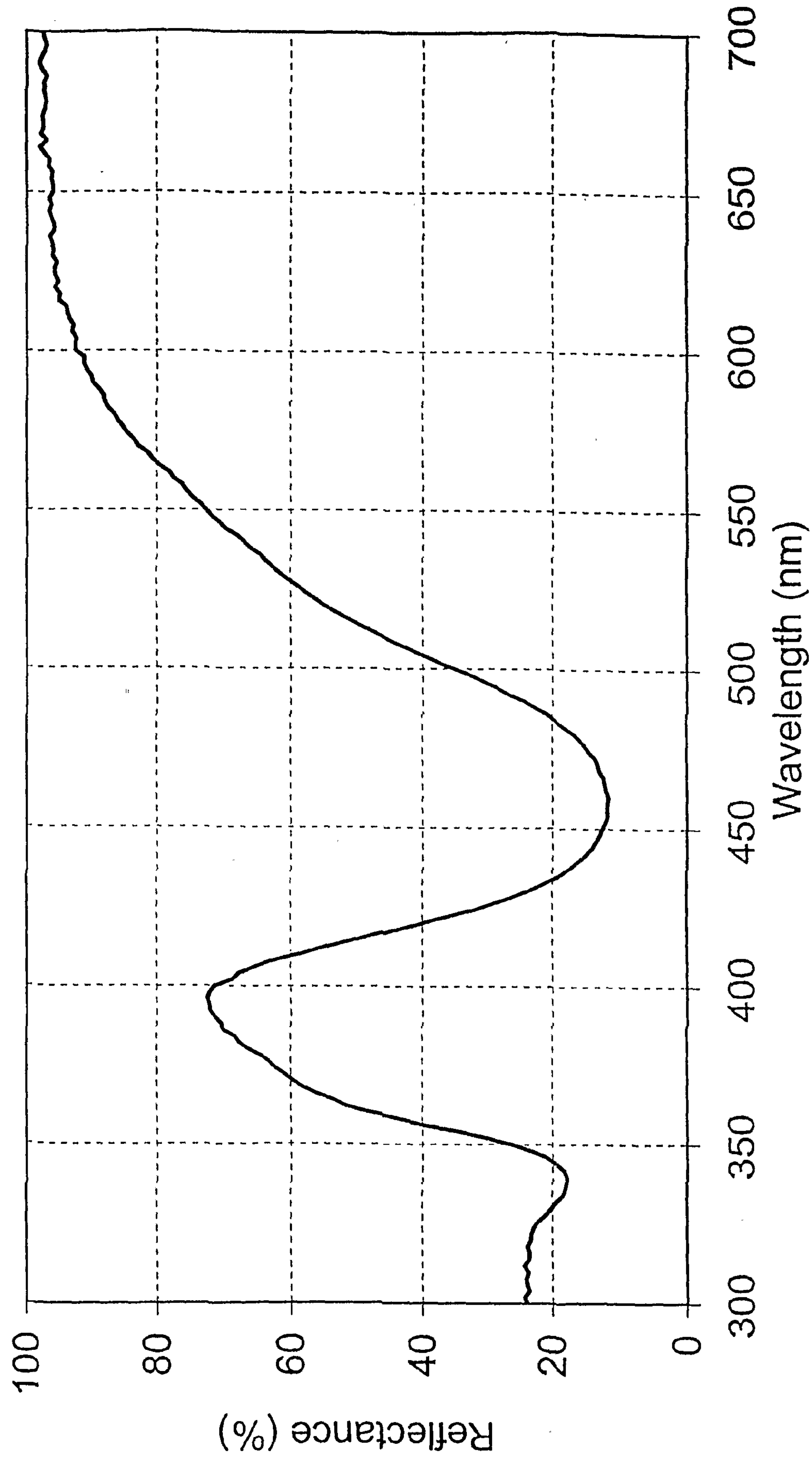
Reflectance (%)
100
80
60
40
20
0
300
350
400
450
500
550
600
650
700
Wavelength (nm)

FIG. 4

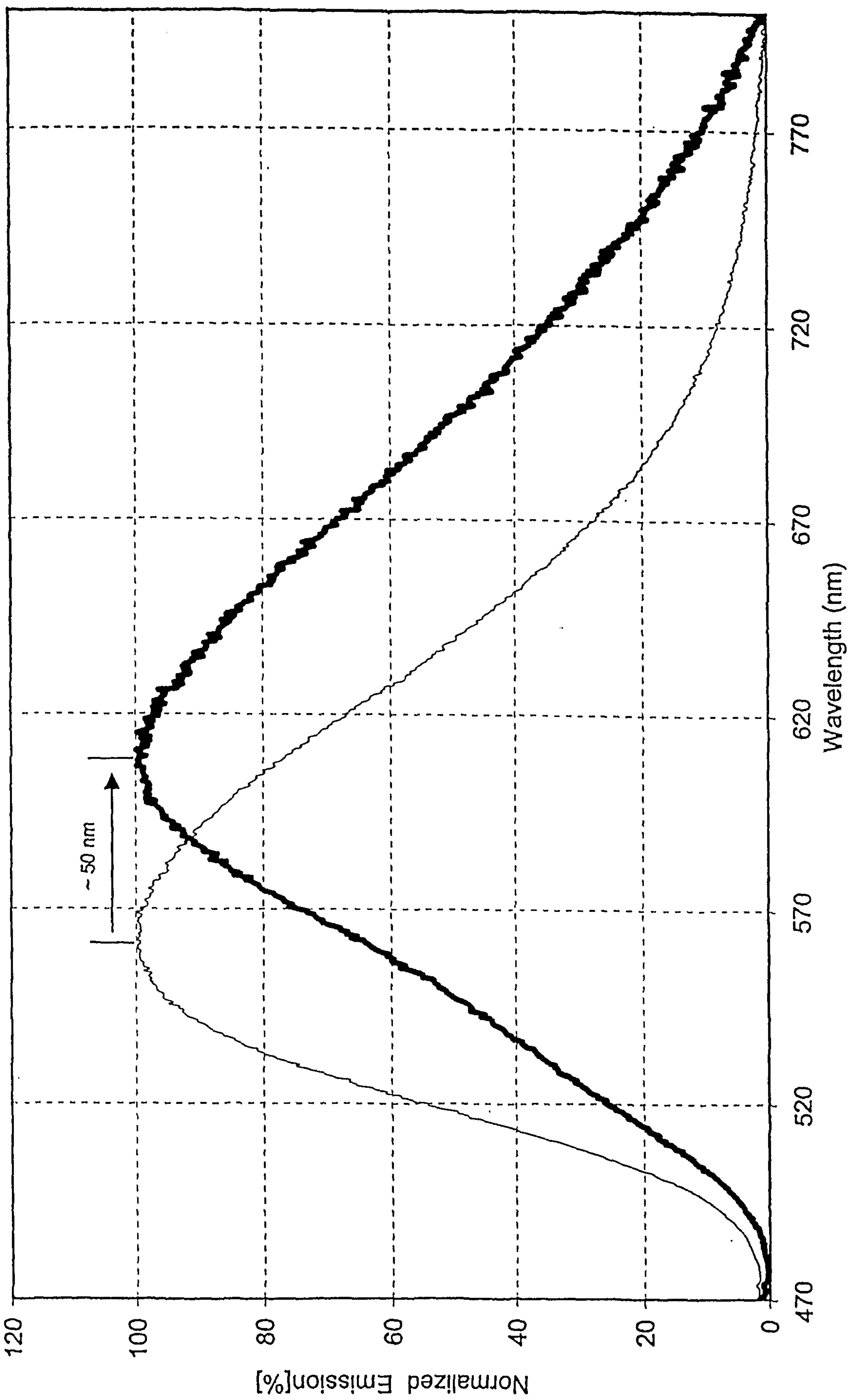
~ 50 nm
Normalized Emission[%]
120
100
80
60
40
20
0
470
520
570
620
670
720
770
Wavelength (nm)

FIG. 5

FIG 6

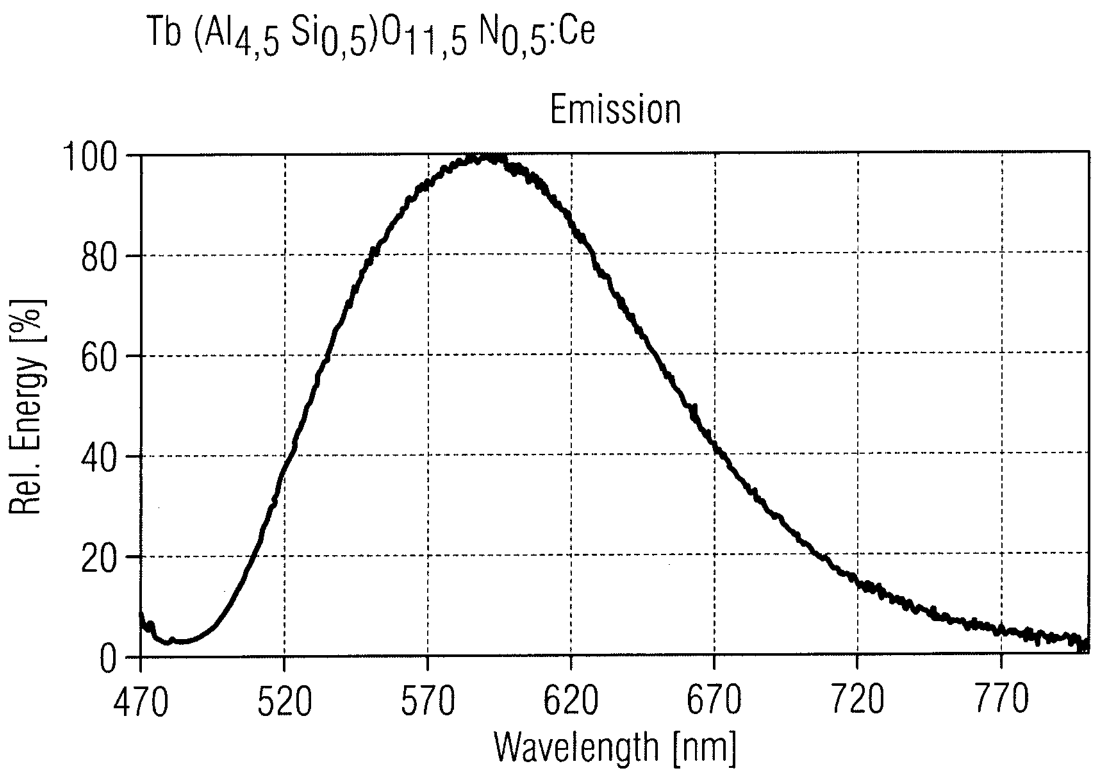
Tb (Al4,5 Si0,5)O11,5 N0,5:Ce
Emission
Rel. Energy [%]
0
20
40
60
80
100
470
520
570
620
670
720
770
Wavelength [nm]

FIG 7

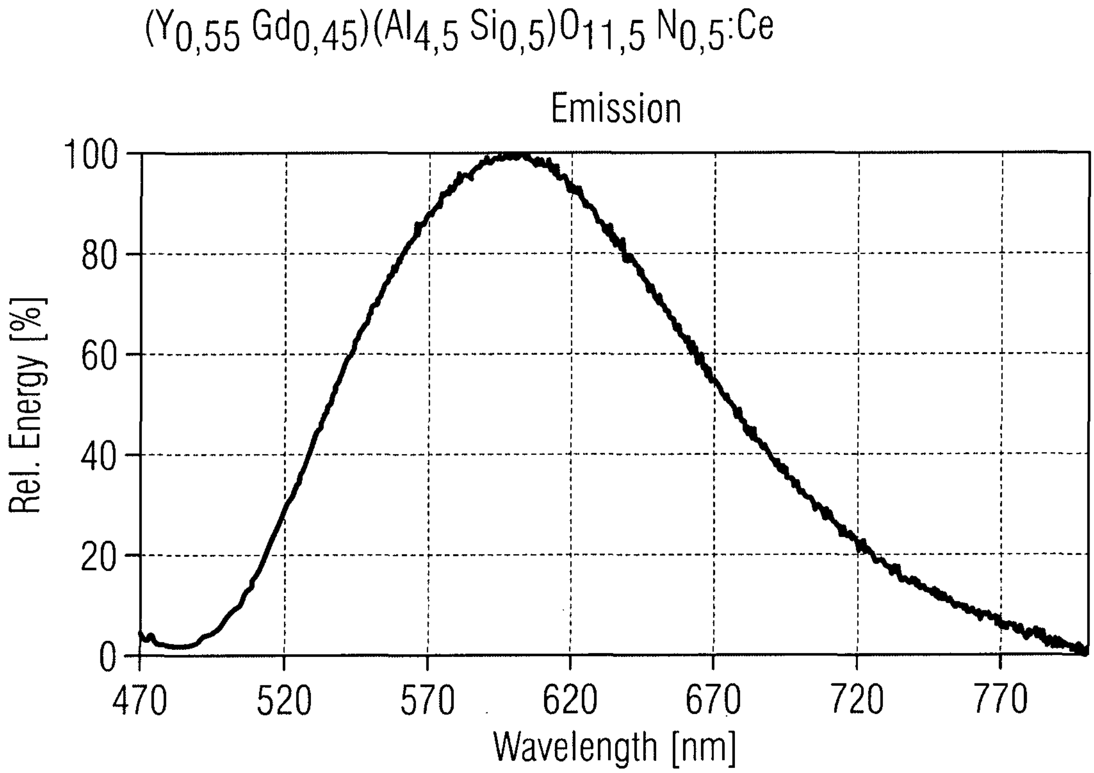
(Y0,55 Gd0,45)(Al4,5 Si0,5)O11,5 N0,5:Ce
Emission
100
80
60
40
20
0
Rel. Energy [%]
470
520
570
620
670
720
770
Wavelength [nm]

FIG 8

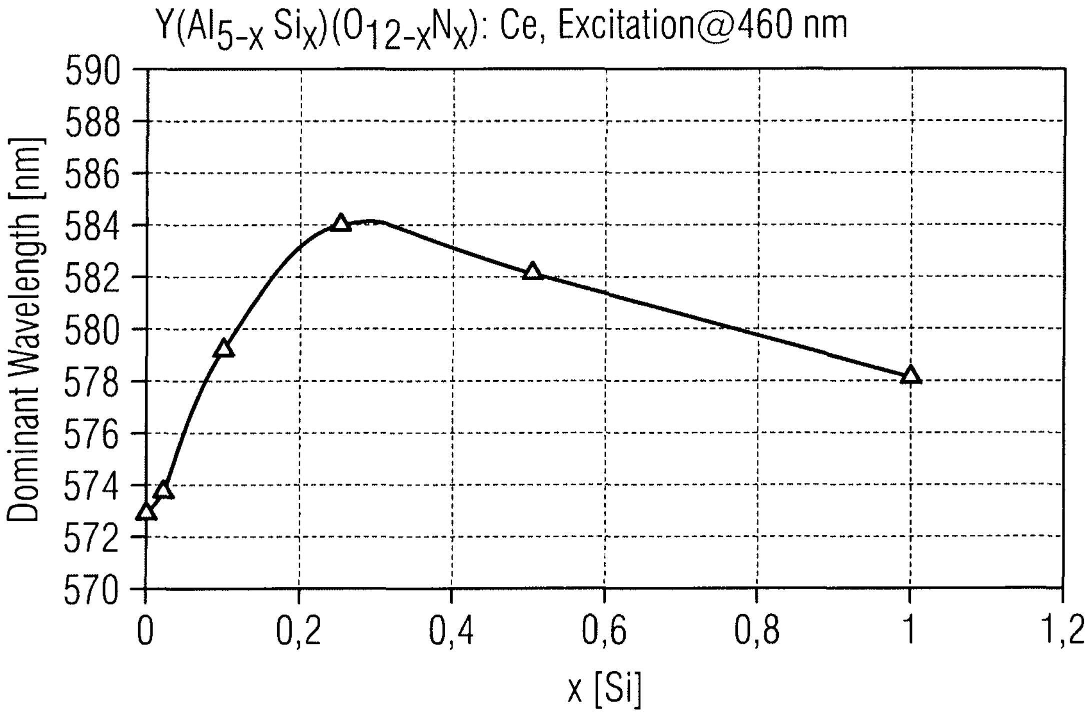
Y(Al5-x Six)(O12-xNx): Ce, Excitation@460 nm
Dominant Wavelength [nm]
590
588
586
584
582
580
578
576
574
572
570
0
0,2
0,4
0,6
0,8
1
1,2
x [Si]

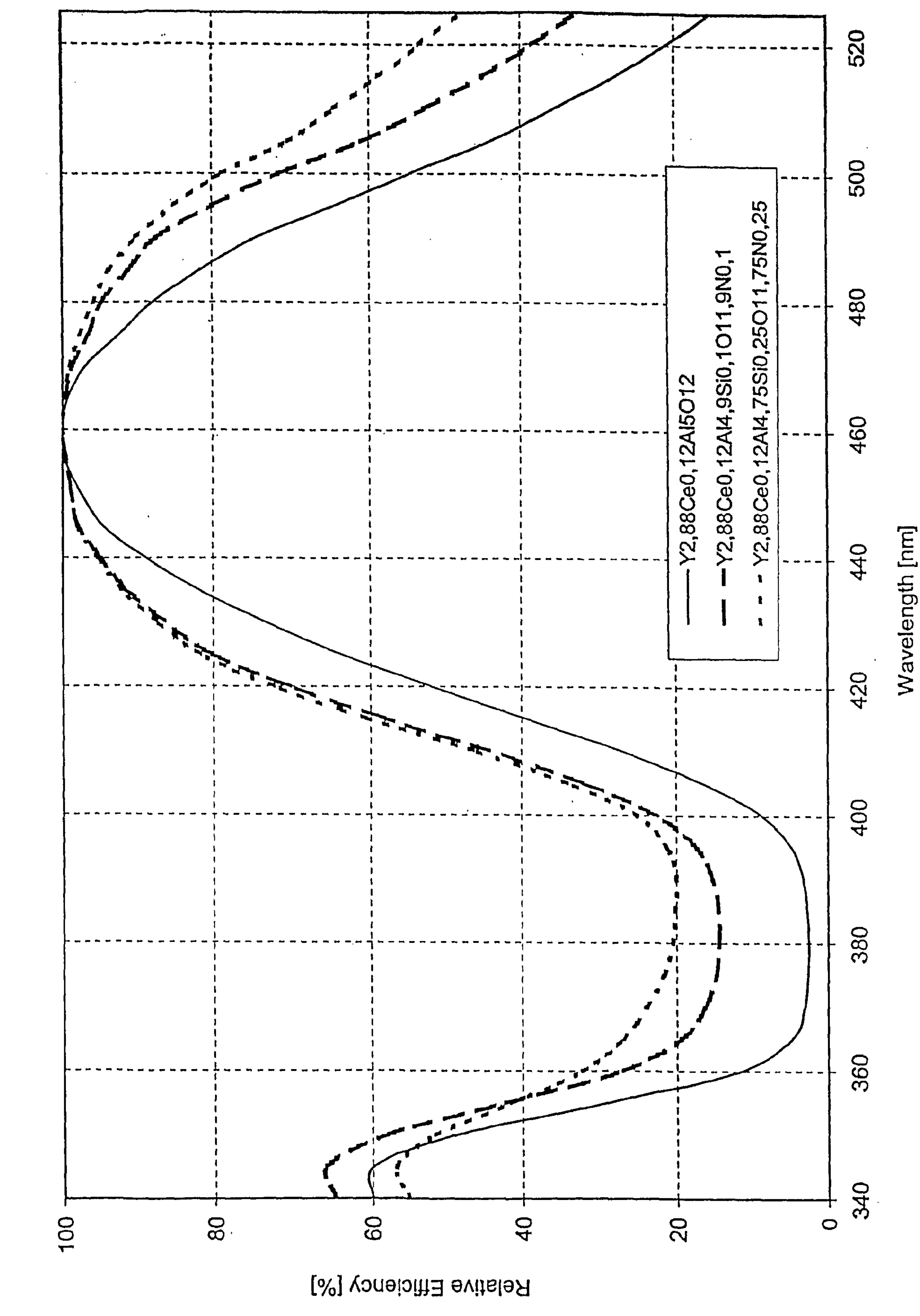
Y2,88Ce0,12Al5O12
Y2,88Ce0,12Al4,9Si0,1O11,9N0,1
Y2,88Ce0,12Al4,75Si0,25O11,75N0,25
Relative Efficiency [%]
100
80
60
40
20
0
Wavelength [nm]
340
360
380
400
420
440
460
480
500
520

FIG. 9

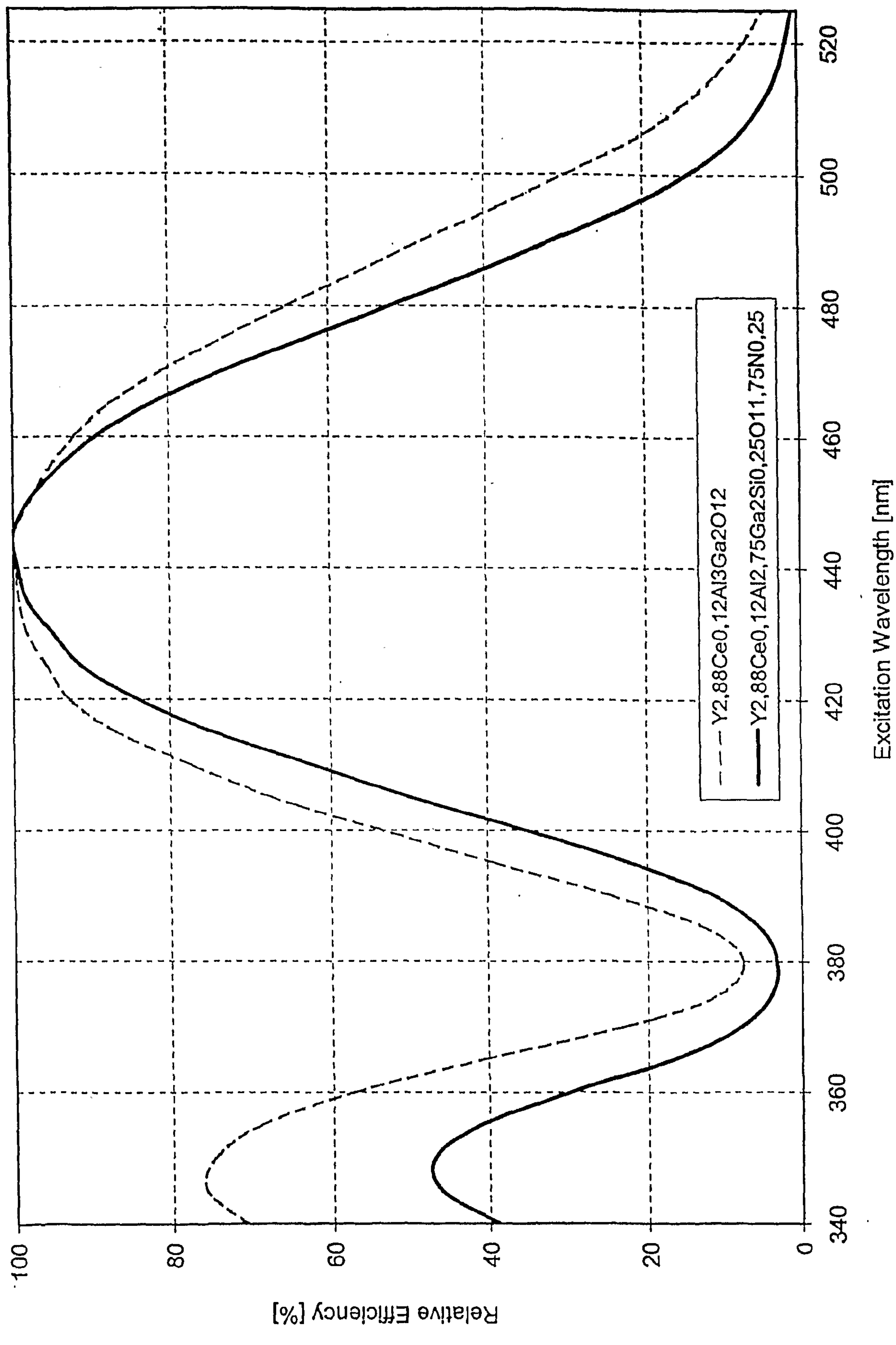
Y2,88Ce0,12Al3Ga2O12
Y2,88Ce0,12Al2,75Ga2Si0,25O11,75N0,25
Relative Efficiency [%]
0
20
40
60
80
100
340
360
380
400
420
440
460
480
500
520
Excitation Wavelength [nm]

FIG. 10

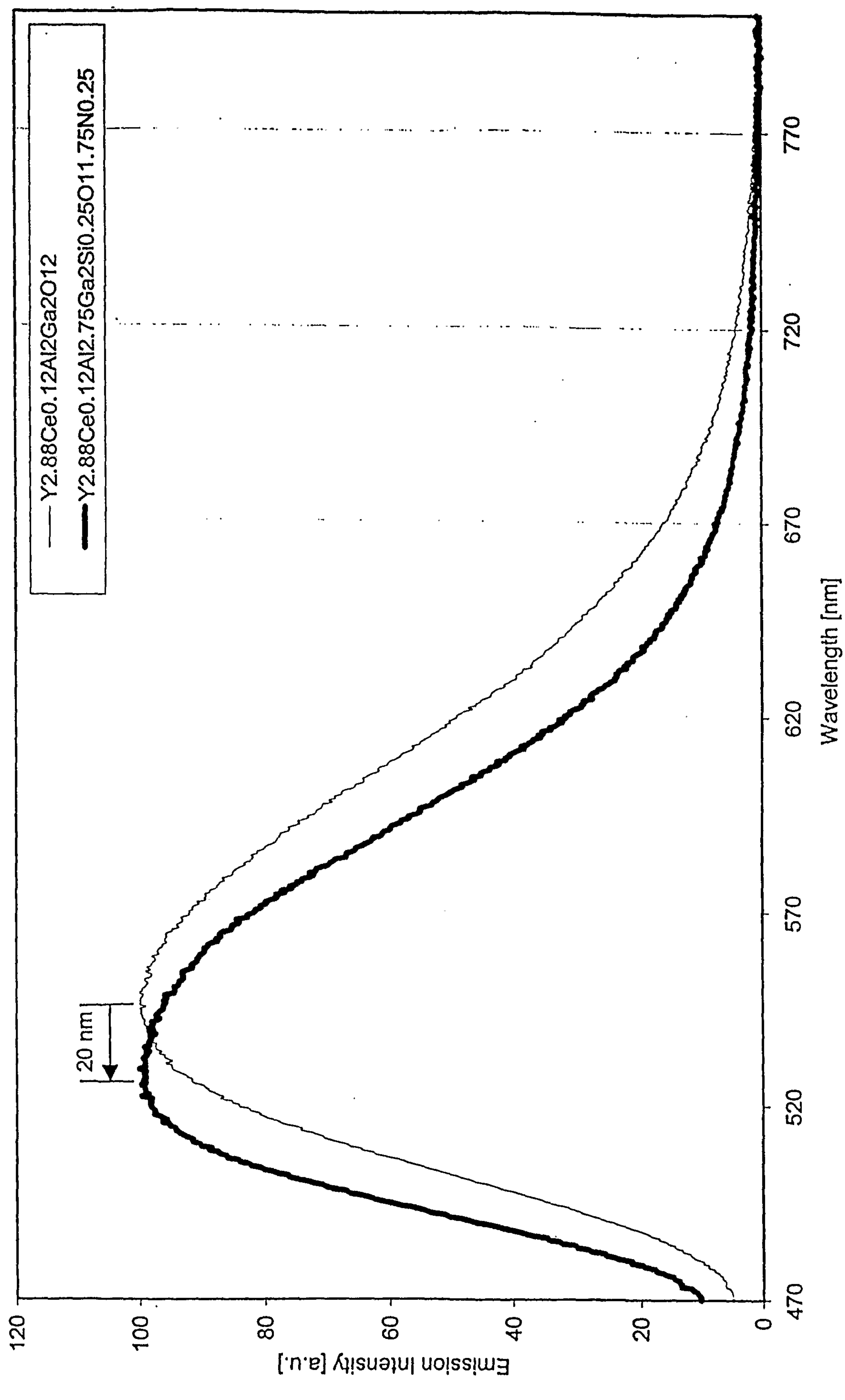
Y2.88Ce0.12Al2Ga2O12
Y2.88Ce0.12Al2.75Ga2Si0.25O11.75N0.25
20 nm
Emission Intensity [a.u.]
0
20
40
60
80
100
120
470
520
570
620
670
720
770
Wavelength [nm]

FIG. 11

FIG 12

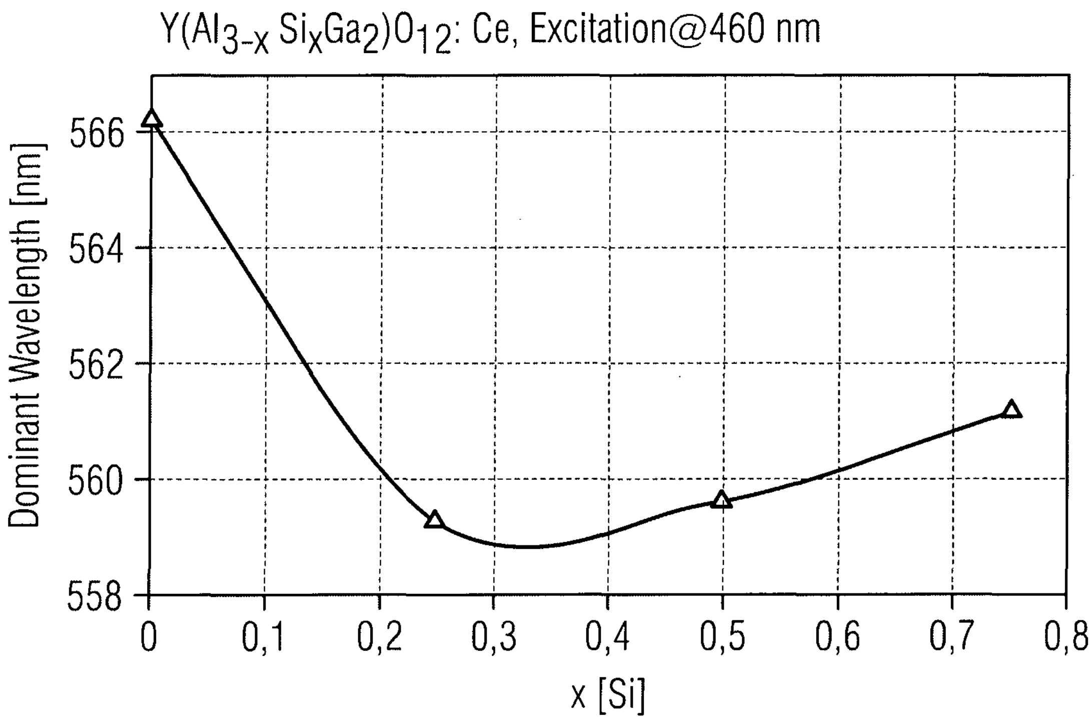
Y(Al3-x SixGa2)O12: Ce, Excitation@460 nm
Dominant Wavelength [nm]
566
564
562
560
558
0
0,1
0,2
0,3
0,4
0,5
0,6
0,7
0,8
x [Si]

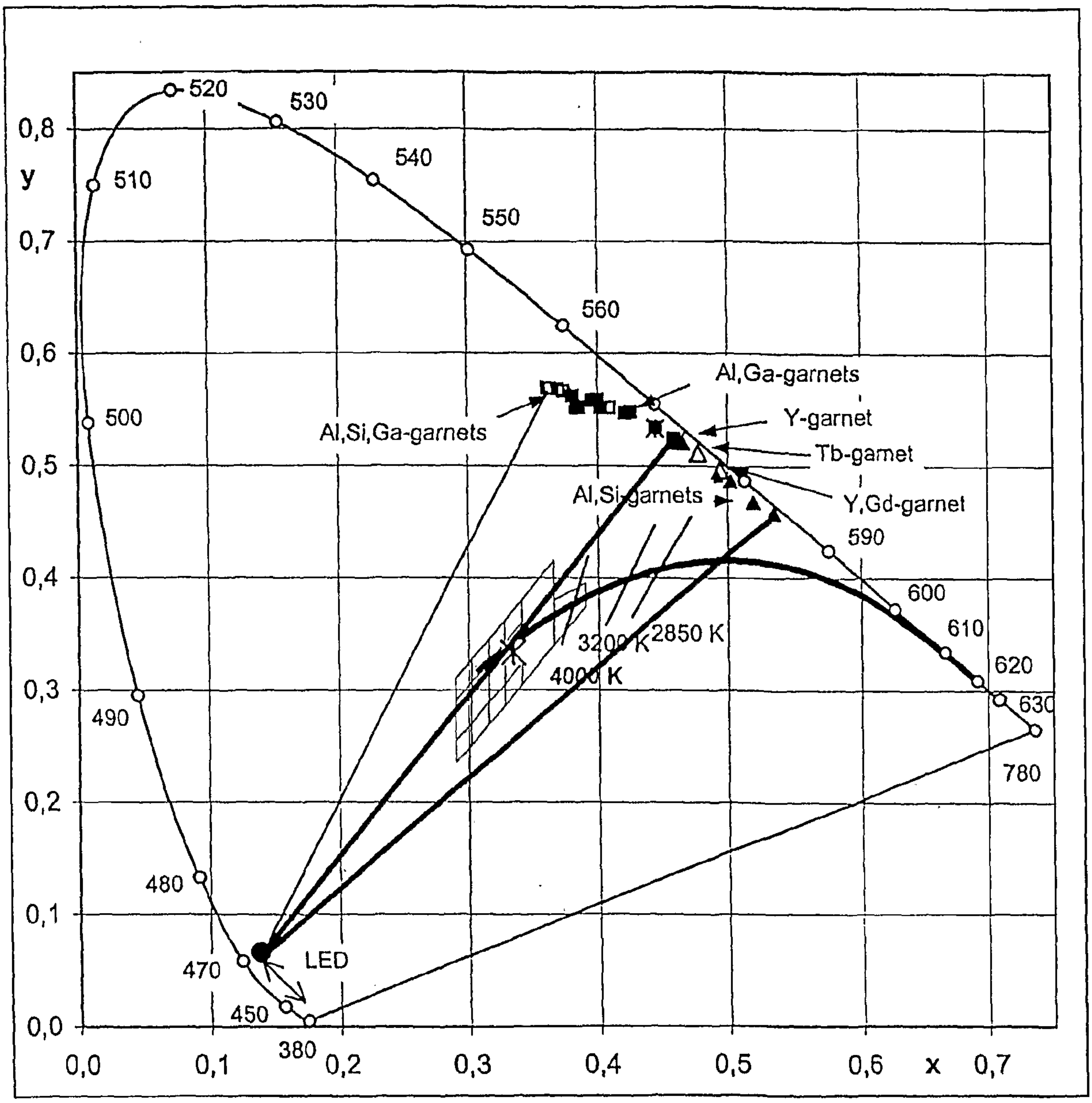
0,8
y
0,7
0,6
0,5
0,4
0,3
0,2
0,1
0,0
0,0
0,1
0,2
0,3
0,4
0,5
0,6
x
0,7
520
530
540
550
560
510
500
490
480
470
450
380
590
600
610
620
630
780
Al,Ga-garnets
Y-garnet
Tb-garnet
Y,Gd-garnet
Al,Si,Ga-garnets
Al,Si-garnets
3200 K
2850 K
4000 K
LED

FIG. 13

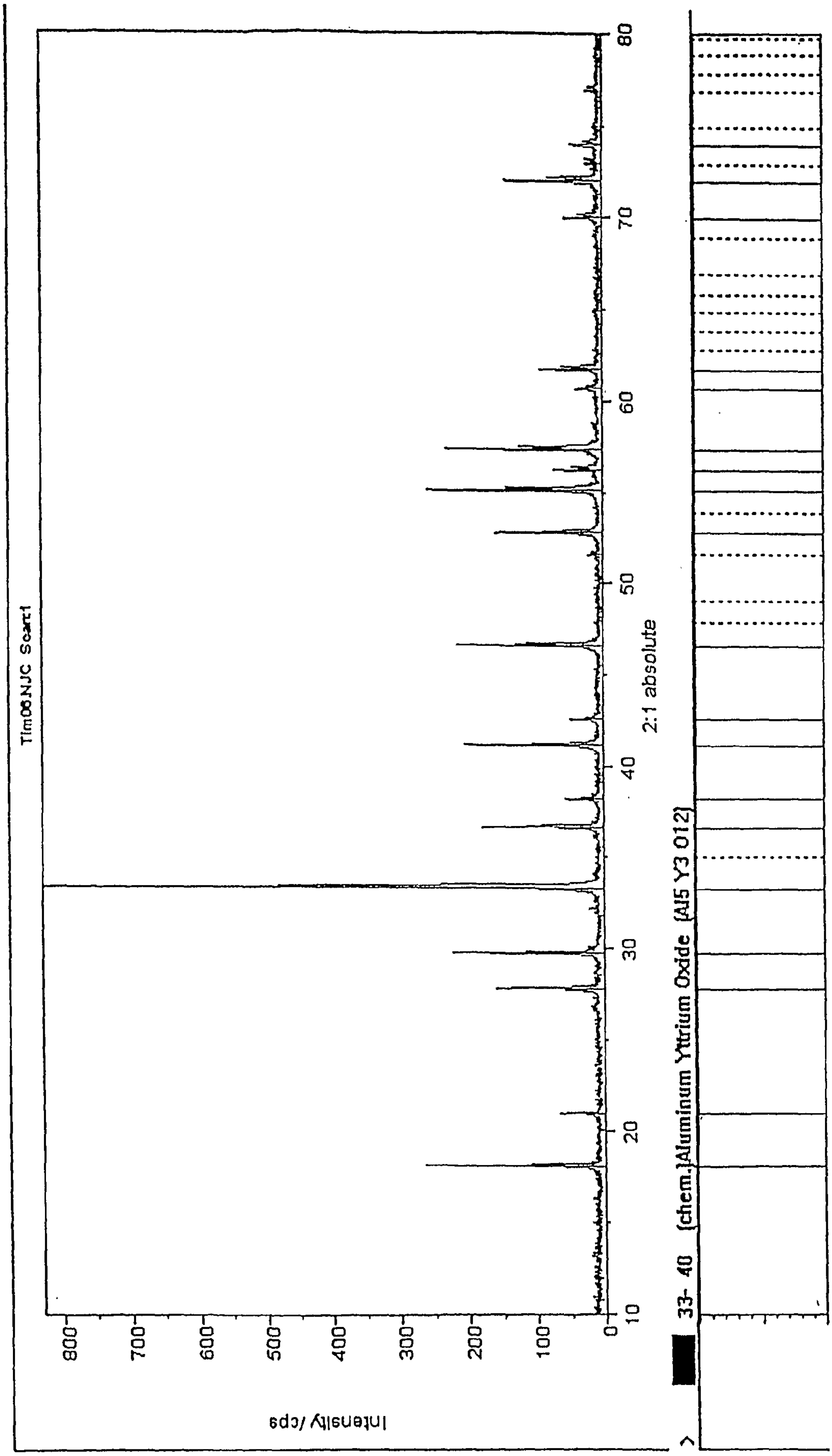
Tim06NJC Scan1
Intensity /cps
800
700
600
500
400
300
200
100
0
10
20
30
40
50
60
70
80
2:1 absolute
33- 40 (chem.) Aluminum Yttrium Oxide (Al5 Y3 O12)

FIG. 14

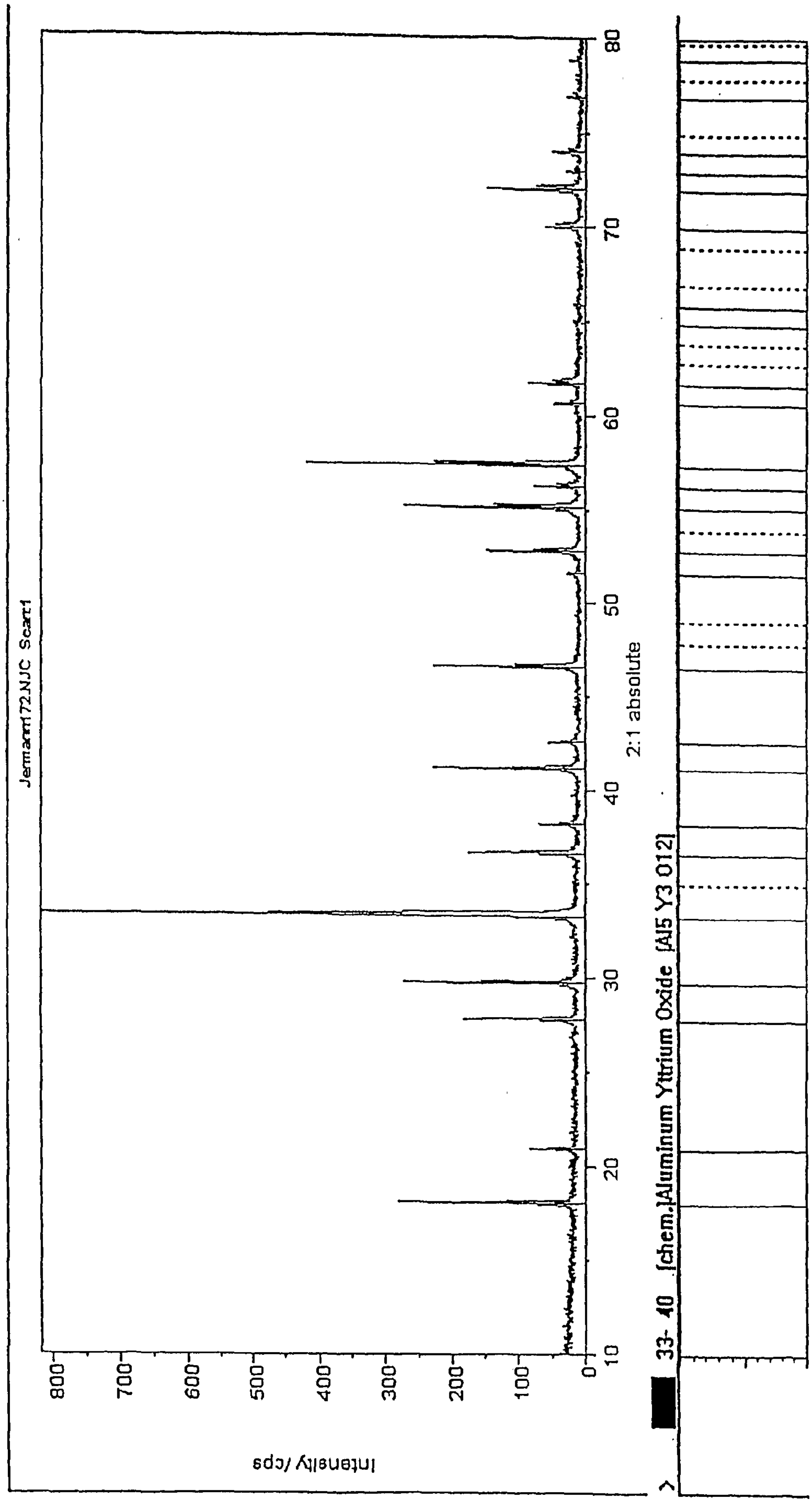
Jemann172.NJC Scan1
Intensity /cps
0
100
200
300
400
500
600
700
800
10
20
30
40
50
60
70
80
2:1 absolute
33- 40 [chem.]Aluminum Yttrium Oxide [Al5 Y3 O12]

FIG. 15

FIG 16

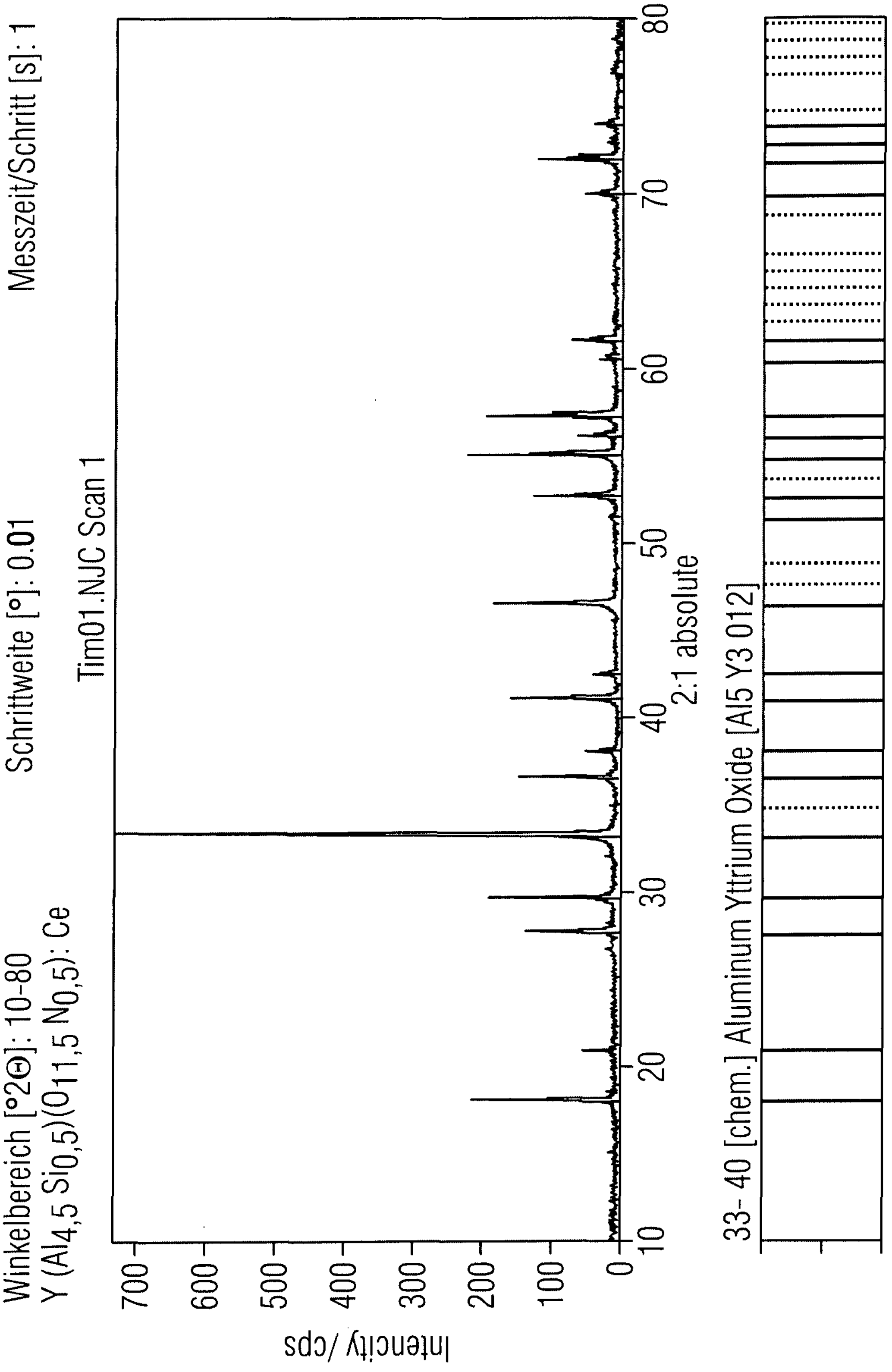

Winkelbereich [°2Θ]: 10-80
Y (Al4,5 Si0,5)(O11,5 N0,5): Ce
Schrittweite [°]: 0.01
Messzeit/Schritt [s]: 1
Tim01.NJC Scan 1
Intencity /cps
700
600
500
400
300
200
100
0
10
20
30
40
50
60
70
80
2:1 absolute
33- 40 [chem.] Aluminum Yttrium Oxide [Al5 Y3 O12]

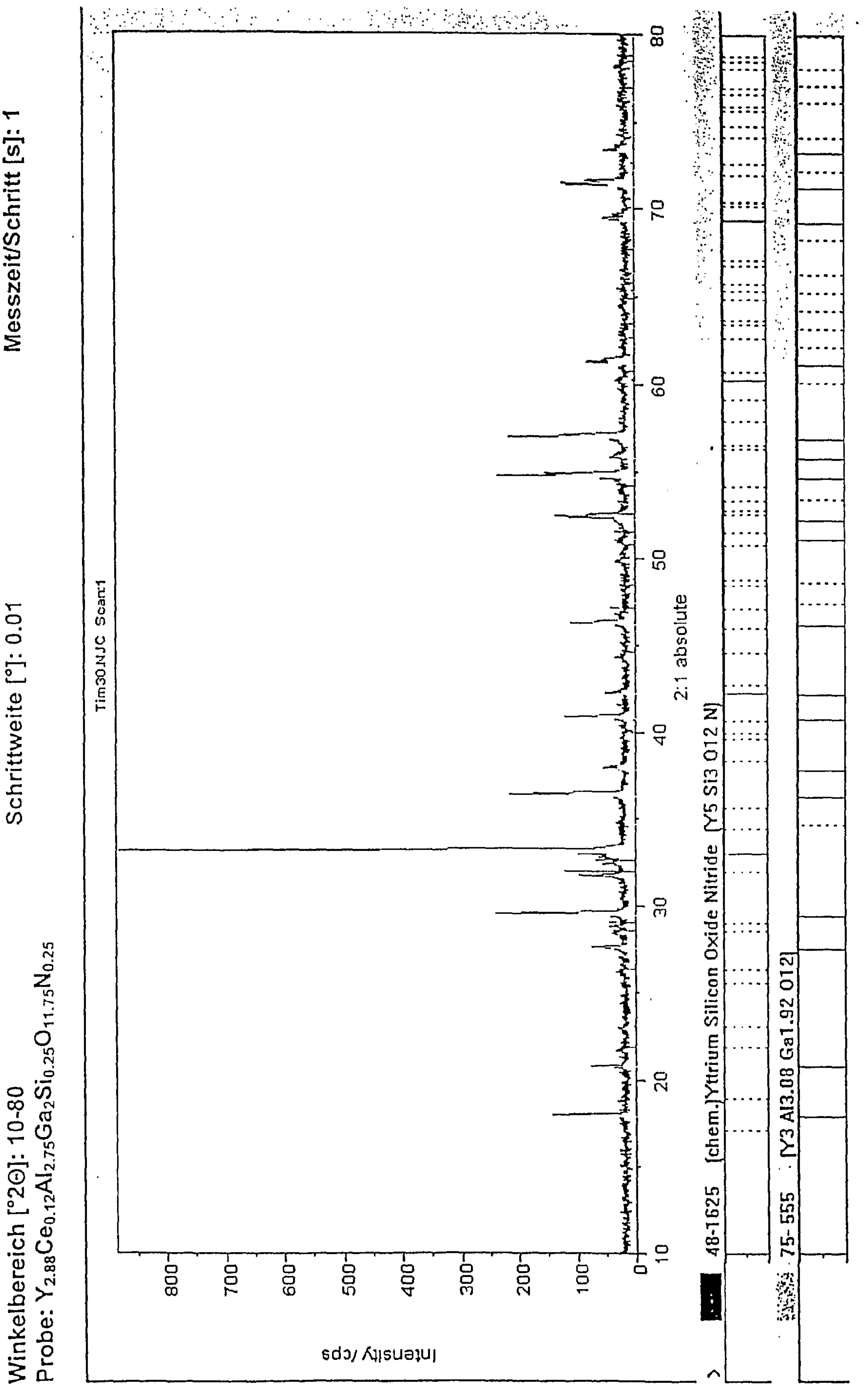

Winkelbereich [°2Θ]: 10-80
Probe: $Y_{2.88}Ce_{0.12}Al_{2.75}Ga_2Si_{0.25}O_{11.75}N_{0.25}$
Schrittweite [°]: 0.01
Messzeit/Schritt [s]: 1
Tim30.NJC Scan1
Intensity /cps
800
700
600
500
400
300
200
100
0
10
20
30
40
50
60
70
80
2:1 absolute
48-1625 (chem.)Yttrium Silicon Oxide Nitride (Y5 Si3 O12 N)
75-555 (Y3 Al3.08 Ga1.92 O12)


FIG. 17

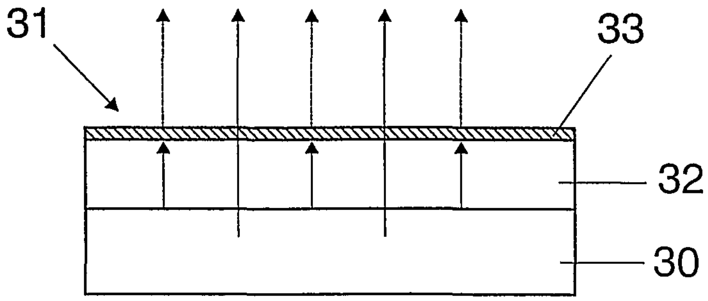


FIG 18

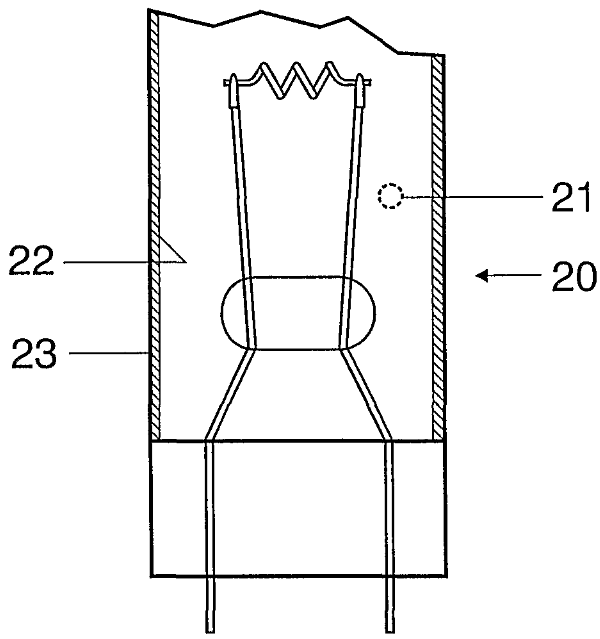


FIG 19

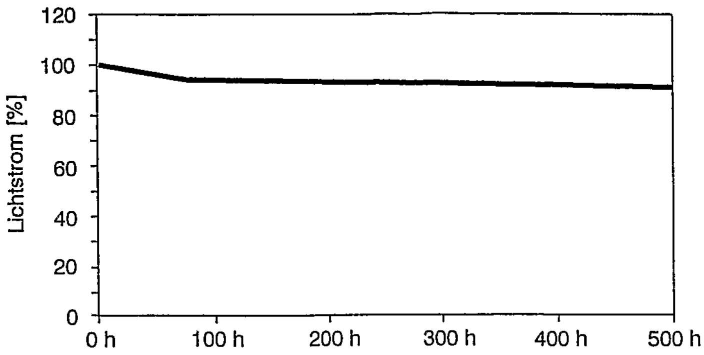


FIG 20a

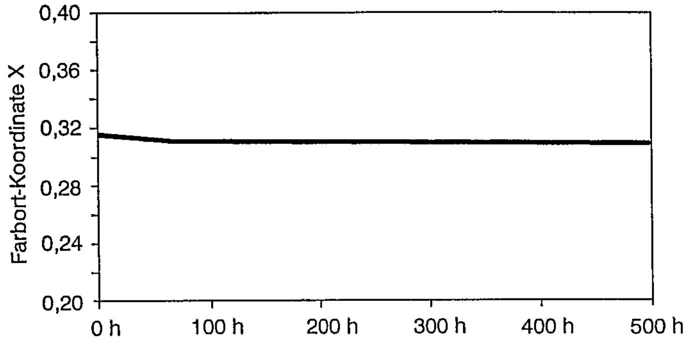


FIG 20b

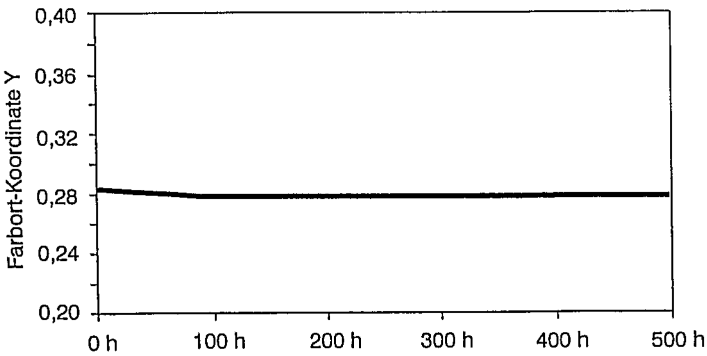


FIG 20c

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 550256 A4
- US 5998925 A
- US 6700322 B
- WO 0210374 A
- US 4810938 A

### In der Beschreibung aufgeführte Nicht-Patentliteratur

- **VAN KREVEL.** On new rare-earth doped M-Si-Al-O-N materials. 2000